Europäisches Patentamt

European Patent Office

Office européen des brevets

(19)

(11) EP 0 940 483 A2

(12) **EUROPEAN PATENT APPLICATION**

(43) Date of publication:
08.09.1999 Bulletin 1999/36

(51) Int Cl.$^6$: **C25D 11/32**

(21) Application number: 99301336.6

(22) Date of filing: 24.02.1999

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• **Sakaguchi, Kiyofumi**<br> **Ohta-ku, Tokyo (JP)**<br>• **Sato, Nobuhiko**<br> **Ohta-ku, Tokyo (JP)** |
| (30) Priority: **26.02.1998 JP 4530998** | (74) Representative:<br>**Beresford, Keith Denis Lewis et al**<br>**BERESFORD & Co.** |
| (71) Applicant: **CANON KABUSHIKI KAISHA**<br>**Ohta-ku, Tokyo (JP)** | **High Holborn**<br>**2-5 Warwick Court**<br>**London WC1R 5DJ (GB)** |

(54) **Anodizing method and apparatus and semiconductor substrate manufacturing method**

(57)     A porous layer having a multilayered structure is formed. An Si substrate (102) to be processed is anodized in a first electrolytic solution (141, 151) while being held between an anode (106) and a cathode (104) in an anodizing bath (101). The first electrolytic solution (141, 151) is exchanged with a second electrolytic solution (142, 152). The Si substrate (102) is anodized again, thereby forming a porous layer having a multilayered structure on the Si substrate (102).

FIG. 2

**Description**

BACKGROUND OF THE INVENTION

FIELD OF THE INVENTION

The present invention relates to an anodizing method and apparatus and a semiconductor substrate manufacturing method and, more particularly, to an anodizing method and apparatus for forming a porous layer on a substrate, and a semiconductor substrate manufacturing method using the anodizing method as part of the process.

DESCRIPTION OF THE RELATED ART

A substrate (SOI substrate) having an SOI (Silicon On Insulator) structure is known as a substrate having a single-crystal Si layer on an insulating layer. A device using this SOI substrate has many advantages that cannot be achieved by ordinary Si substrates. Examples of the advantages are as follows.

  (1) The integration degree can be increased because dielectric isolation is easy.
  (2) The radiation resistance can be increased.
  (3) The operating speed of the device can be increased because the stray capacitance is small.
  (4) No well step is necessary.
  (5) Latch-up can be prevented.
  (6) A completely depleted field-effect transistor can be formed by thin film formation.

Since an SOI structure has the above various advantages, researches have been made on its formation method for several decades.
As one SOI technology, the SOS (Silicon On Sapphire) technology by which Si is heteroepitaxially grown on a single-crystal sapphire substrate by CVD (Chemical Vapor Deposition) has been known for a long time. This SOS technology once earned a reputation as the most matured SOI technology. However, the SOS technology has not been put into practical use to date because, e.g., a large amount of crystal defects are produced by lattice mismatch in the interface between the Si layer and the underlying sapphire substrate, aluminum that forms the sapphire substrate mixes in the Si layer, the substrate is expensive, and it is difficult to obtain a large area.
Attempts have recently been made to realize the SOI structure without using any sapphire substrate. The attempts are roughly classified into two methods.
In the first method, the surface of a single-crystal Si substrate is oxidized, and a window is formed in the oxide film ($SiO_2$ layer) to partially expose the Si substrate. Single-crystal Si is epitaxially grown laterally using the exposed portion as a seed, thereby forming a single-crystal Si layer on $SiO_2$ (in this method, an Si layer is deposited on an $SiO_2$ layer).
In the second method, a single-crystal Si substrate itself is used as an active layer, and an $SiO_2$ layer is formed on the lower surface of the substrate (in this method, no Si layer is deposited).
As a means for realizing the first method, a technique of directly epitaxially growing single-crystal Si in the horizontal direction from the single-crystal Si layer by CVD (CVD), a technique of depositing amorphous Si and epitaxially growing single-crystal Si laterally in the solid phase by annealing (solid phase epitaxial growth), a technique of irradiating an amorphous silicon layer or a polysilicon layer with a focused energy beam such as an electron beam or laser beam to grow a single-crystal Si layer on an $SiO_2$ layer by melting recrystallization (beam annealing), or a method of scanning band-shaped melting regions by a rod-like heater (zone melting recrystallization) is known.
All of these methods have both advantages and disadvantages and many problems of controllability, productivity, uniformity, and quality, and therefore have not been put into practical use in terms of industrial applications. For example, CVD requires sacrifice oxidation to form a flat thin film. Solid phase epitaxial growth is poor in crystallinity. In beam annealing, the process time required to scan the focused beam and controllability for beam superposition or focal point adjustment pose problems. Zone melting recrystallization is the most matured technique, and relatively large-scaled integrated circuits have been fabricated on a trial basis. However, since a number of crystal defects such as a subboundary undesirably remain, minority carrier devices cannot be created.
As the above second method, i.e., as the method without using the Si substrate as a seed for epitaxial growth, the following four techniques can be used.
As the first technique, an oxide film is formed on a single-crystal Si substrate having a V-shaped groove formed in the surface by anisotropic etching. A polysilicon layer having nearly the same thickness as that of the single-crystal Si substrate is deposited on the oxide film. After this, the single-crystal Si substrate is polished from the lower surface, thereby forming, on the thick polysilicon layer, a substrate having a single-crystal Si region surrounded and dielectrically isolated by the V-shaped groove. With this technique, a substrate having satisfactory crystallinity can be formed. However, there are problems of controllability and productivity in association with the process of depositing polysilicon as thick as several hundred micron or the process of polishing the single-crystal Si substrate from the lower surface to leave the isolated Si active layer.

The second technique is SIMOX (Separation by Ion Implanted Oxygen). In this technique, oxygen ions are implanted into a single-crystal Si substrate to form an $SiO_2$ layer. In this technique, to form an $SiO_2$ layer in a substrate, oxygen ions must be implanted at a dose of $10^{18}$ (ions/cm$^2$) or more. This implantation takes a long time to result in low productivity and high manufacturing cost. In addition, since a number of crystal defects are generated, the quality is too low to manufacture minority carrier devices.

As the third technique, an SOI structure is formed by dielectric isolation by oxidizing a porous Si layer. In this technique, an n-type Si island is formed on the surface of a p-type single-crystal Si substrate by proton ion implantation (Imai et al., J. Crystal Growth, vol. 63, 547 (1983)) or epitaxial growth and patterning. This substrate is anodized in an HF solution to convert only the p-type Si substrate around the n-type Si island into a porous structure. After this, the n-type Si island is dielectrically isolated by accelerated oxidation. In this technique, since the Si region to be isolated must be determined before the device process, the degree of freedom in device design is limited.

As the fourth technique, an SOI structure is formed by bonding a single-crystal Si substrate to another thermally oxidized single-crystal Si substrate by annealing or an adhesive. In this technique, an active layer for forming a device must be uniformly thin. More specifically, a single-crystal Si substrate having a thickness of several hundred micron must be thinned down to the micron order or less.

To thin the substrate, polishing or selective etching can be used.

A single-crystal Si substrate can hardly be uniformly thinned by polishing. Especially, thinning to the submicron order, the variation range is several ten %. As the wafer size becomes large, this difficulty becomes more pronounced.

Selective etching is effective to uniformly thin the substrate. However, the selectivity ratio is as low as about $10^2$, the surface planarity after etching is poor, and the crystallinity of the SOI layer is unsatisfactory.

A transparent substrate represented by a glass substrate is important in forming a contact sensor as a light-receiving element or a projection liquid crystal display device. To realize highly precise pixels (picture elements) having higher density and resolution for the sensor or display device, a high-performance driving element is required. For this purpose, a demand has arisen for a technique of forming a single-crystal Si layer having excellent crystallinity on a transparent substrate.

However, when an Si layer is deposited on a transparent substrate represented by a glass substrate, only an amorphous Si layer or a polysilicon layer is obtained. This is because the transparent substrate has an amorphous crystal structure, and the Si layer formed on the substrate reflects the disorderliness of the crystal structure of the transparent substrate.

The present applicant has disclosed a new SOI technology in Japanese Patent Laid-Open No. 5-21338. In this technique, a first substrate obtained by forming a porous layer on a single-crystal Si substrate and a non-porous single-crystal layer on its surface is bonded to a second substrate via an insulating layer. After this, the bonded substrate stack is separated into two substrates at the porous layer, thereby transferring the non-porous single-crystal layer to the second substrate. This technique is advantageous because the film thickness uniformity of the SOI layer is good, the crystal defect density in the SOI layer can be decreased, the surface planarity of the SOI layer is good, no expensive manufacturing apparatus with special specifications is required, and SOI substrates having about several hundred angstrom to 10-μm thick SOI films can be manufactured by a single manufacturing apparatus.

The present applicant has also disclosed, in Japanese Patent Laid-Open No. 7-302889, a technique of bonding first and second substrates, separating the first substrate from the second substrate without destroying the first substrate, smoothing the surface of the separated first substrate, forming a porous layer again, and reusing the porous layer. Since the first substrate is not wasted, this technique is advantageous in largely reducing the manufacturing cost and simplifying the manufacturing process.

To separate the bonded substrate stack into two substrates while destroying neither of the first and second substrates, for example, the two substrates are pulled in opposite directions while applying a force in a direction perpendicular to the bonding interface, shearing stress is applied parallel to the bonding interface (for example, the two substrates are moved in opposite directions in a plane parallel to the bonding interface, or the two substrates are rotated in opposite directions while applying a force in the circumferential direction), a pressure is applied in a direction perpendicular to the bonding interface, a wave energy such as an ultrasonic wave is applied to the separation region, a peeling member (e.g., a sharp blade such as knife) is inserted into the separation region parallel to the bonding interface from the side surface side of the bonded substrate stack, the expansion energy of a substance filling the pores of the porous layer functioning as the separation region is used, the porous layer functioning as the separation region is thermally oxidized from the side surface of the bonded substrate stack to expand the volume of the porous layer and separate the substrates, or the porous layer functioning as the separation region is selectively etched from the side surface of the bonded substrate stack to separate the substrates.

Porous Si was found in 1956 by Uhlir et al. who were studying electropolishing of semiconductors (A. Uhlir, Bell Syst. Tech. J., vol. 35, 333 (1956)). Porous Si can be formed by anodizing an Si substrate in an HF solution.

Unagami et al. studied the dissolution reaction of Si upon anodizing and reported that holes were necessary for anodizing reaction of Si in an HF solution, and the reaction was as follows (T. Unagami, J. Electrochem. Soc., vol. 127, 476 (1980)).

$$Si + 2HF + (2 - n)e^+ \rightarrow SiF_2 + 2H^+ \ ne^-$$

$$SiF_2 + 2HF \rightarrow SiF_4 + H_2$$

$$SiF_4 + 2HF \rightarrow H_2SiF_6$$

or

$$Si + 4HF + (4 - \lambda)e^+ \rightarrow SiF_4 + 4H^+ \ \lambda e^-$$

$$SiF_4 + 2HF \rightarrow H_2SiF_6$$

where $e^+$ and $e^-$ each represent a hole and an electron, respectively, and $n$ and $\lambda$ are the number of holes necessary to dissolve one Si atom. According to them, when $n > 2$ or $\lambda > 4$, porous Si is formed.

The above fact suggests that p-type Si having holes is converted into porous Si while n-type Si is not converted. The selectivity in this conversion has been reported by Nagano et at. and Imai (Nagano, Nakajima, Anno, Onaka, and Kajiwara, IEICE Technical Report, vol. 79, SSD79-9549 (1979)), (K. Imai, Solid-State Electronics, vol. 24, 159 (1981)).

However, it has also been reported that n-type at a high concentration is converted into porous Si (R. P. Holmstrom and J. Y. Chi, Appl. Phys. Lett., vol. 42, 386 (1983)). Hence, it is important to select a substrate which can be converted into a porous Si substrate independently of p- or n-type.

To form a porous layer on an Si substrate, a pair of electrodes are supported in a process bath filled with an HF solution, the Si substrate is held between the electrodes, and a current is flowed across the electrodes. In this process, the metal element of the anode dissolves into the HF solution to contaminate the Si substrate. The present applicant has disclosed an anodizing apparatus for solving this problem in Japanese Patent Laid-Open No. 6-275598. In the anodizing apparatus disclosed in Japanese Patent Laid-Open No. 6-275598, a conductive diaphragm formed from an Si material is inserted between an Si substrate and an anode, and contamination of the Si substrate by the metal element of the anode is prevented by this conductive electrode.

To facilitate separation of the bonded substrate stack, the porosity of the porous layer is preferably made large to some degree. To form a high-quality single-crystal Si layer on a porous layer, the porosity is preferably made small to some degree. Therefore, to facilitate separation of the bonded substrate stack and simultaneously form a high-quality single-crystal Si layer on the porous layer, a porous layer with a multilayered structure in which porous layers having different porosities are stacked is preferably formed.

## SUMMARY OF THE INVENTION

The present invention has been made in consideration of the above requirement, and has as its object to provide a method and apparatus suitable to form a porous region with a multilayered structure, and a semiconductor substrate manufacturing method using this method.

According to an aspect of the present invention, there is provided an anodizing method of forming a porous layer on a substrate, characterized by comprising preparing an anodizing bath used to anodize a substrate, anodizing the substrate to be processed in a first electrolytic solution while holding the substrate between an anode and a cathode in the anodizing bath, exchanging the first electrolytic solution with a second electrolytic solution, and anodizing the substrate in the second electrolytic solution, thereby forming a porous layer having a multilayered structure on the substrate.

In the anodizing method, a current density of a current to be flowed across the anode and the cathode is preferably changed between anodizing using the first electrolytic solution and anodizing using the second electrolytic solution.

In the anodizing method, a conductive diaphragm is preferably inserted between the anode and the substrate to be processed to prevent contamination of the substrate by the anode.

In the anodizing method, the conductive diaphragm is preferably arranged to flow the whole current from the anode to the substrate to be processed through the conductive diaphragm.

In the anodizing method, the conductive diaphragm is preferably arranged to cover a surface of the anode that opposes a backside surface of the substrate to be processed.

In the anodizing method, the conductive diaphragm is preferably arranged to isolate an electrolytic solution in contact with a surface of the substrate to be processed, that is on the anode side, from an electrolytic solution in contact with the anode.

In the anodizing method, at least a surface of the conductive diaphragm that opposes the substrate to be processed is preferably formed from a silicon material.

The anodizing method preferably further comprises changing the conductive diaphragm every time an anodizing condition is changed.

The anodizing method preferably further comprises preparing a conductive diaphragm corresponding to each anodizing condition, and every time the anodizing condition is changed, using a conductive diaphragm corresponding to the condition.

The anodizing method preferably further comprises forming a porous layer having a relatively low porosity as a surface layer of the substrate to be processed, and forming a porous layer having a relatively high porosity as an underlayer of the surface layer.

The anodizing method preferably further comprises anodizing to form a porous layer having a porosity of not more than 30% as the surface layer.

The anodizing method preferably further comprises anodizing to form a porous layer having a porosity of not less than 30% as the underlayer of the surface layer.

The anodizing method preferably further comprises anodizing to form a porous layer having a thickness of not more than 5 μm as the underlayer of the surface layer.

According to another aspect of the present invention, there is provided an anodizing method of forming a porous layer on a substrate, characterized by comprising preparing at least two anodizing baths used to anodize a substrate, anodizing the substrate to be processed while holding the substrate between an anode and a cathode in one anodizing bath, and anodizing the substrate while holding the substrate between an anode and a cathode in the next anodizing bath, thereby forming a porous layer having a multilayered structure on the substrate.

In the other anodizing method, different electrolytic solutions are preferably used as electrolytic solutions used for anodizing in all or some of the at least two anodizing baths.

In the other anodizing method, a current density of a current to be flowed across the anode and the cathode is preferably changed in anodizing in all or some of the at least two anodizing baths.

In the other anodizing method, a conductive diaphragm is preferably inserted between the anode and the substrate to be processed to prevent contamination of the substrate by the anode.

In the other anodizing method, the conductive diaphragm is preferably arranged to flow the whole current from the anode to the substrate to be processed through the conductive diaphragm.

In the other anodizing method, the conductive diaphragm is preferably arranged to cover a surface of the anode that opposes a backside surface of the substrate to be processed.

In the other anodizing method, the conductive diaphragm is preferably arranged to isolate an electrolytic solution in contact with a surface of the substrate to be processed, that is on the anode side, from an electrolytic solution in contact with the anode. In the other anodizing method, at least a surface of the conductive diaphragm that opposes the substrate to be processed is preferably formed from a silicon material.

The other anodizing method preferably further comprises changing the conductive diaphragm every time an anodizing condition is changed.

The other anodizing method preferably further comprises preparing a conductive diaphragm corresponding to each anodizing condition, and every time the anodizing condition is changed, using a conductive diaphragm corresponding to the condition.

The other anodizing method preferably further comprises forming a porous layer having a relatively low porosity as a surface layer of the substrate to be processed, and forming a porous layer having a relatively high porosity as an underlayer of the surface layer.

The other anodizing method preferably further comprises anodizing to form a porous layer having a porosity of not more than 30% as the surface layer.

The other anodizing method preferably further comprises anodizing to form aporous layer having a porosity of not less than 30% as the underlayer of the surface layer.

The other anodizing method preferably further comprises anodizing to form a porous layer having a thickness of not more than 5 μm as the underlayer of the surface layer.

According to still another aspect of the present invention, there is provided a semiconductor substrate manufacturing method characterized by comprising the steps of processing a first substrate using any one of the above anodizing methods to form a porous layer having a multilayered structure on the first substrate, forming at least one non-porous layer on the porous layer, bonding a second substrate to a surface of the non-porous layer of the first substrate, separating a bonded substrate stack to a side of the first substrate and a side of the second substrate at a portion of the porous layer, and removing the porous layer left on the side of the separated second substrate.

The semiconductor substrate manufacturing method preferably further comprises the step of removing the porous layer left on the side of the separated first substrate to allow reuse of the first substrate.

In the semiconductor substrate manufacturing method, the separation step preferably comprises separating the bonded substrate stack at a portion having a high porosity in the porous layer having the multilayered structure.

In the semiconductor substrate manufacturing method, the non-porous layer preferably contains a single-crystal silicon layer.

In the semiconductor substrate manufacturing method, the non-porous layer preferably comprises a single-crystal silicon layer and a silicon oxide layer which are sequentially formed on the porous layer.

In the semiconductor substrate manufacturing method, the non-porous layer preferably contains a compound semiconductor layer.

In the semiconductor substrate manufacturing method, the second substrate preferably comprises a silicon substrate.

In the semiconductor substrate manufacturing method, the second substrate preferably comprises a substrate having a silicon oxide layer formed on a surface to be bonded to the first substrate.

In the semiconductor substrate manufacturing method, the second substrate preferably comprises a transparent substrate.

The semiconductor substrate manufacturing method preferably further comprises, after the step of removing the porous layer, the step of planarizing a surface layer on the side of the second substrate.

In the semiconductor substrate manufacturing method, the planarization step preferably comprises annealing in an atmosphere containing hydrogen.

In the semiconductor substrate manufacturing method, the step of removing the porous layer preferably comprises selectively etching the porous layer using, as an etchant, any one of

a) hydrofluoric acid,
b) a mixed solution prepared by adding at least one of an alcohol and hydrogen peroxide to hydrofluoric acid,
c) buffered hydrofluoric acid, and
d) a mixed solution prepared by adding at least one of an alcohol and hydrogen peroxide to buffered hydrofluoric acid.

In the semiconductor substrate manufacturing method, the step of removing the porous layer preferably comprises selectively etching the porous layer using an etchant whose etching rate for the porous layer is higher than that for a compound semiconductor.

In the semiconductor substrate manufacturing method, the step of removing the porous layer preferably comprises selectively polishing the porous layer using the non-porous layer as a stopper.

In the semiconductor substrate manufacturing method, the bonding step preferably comprises the step of bringing the first substrate having the non-porous layer into tight contact with the second substrate.

In the semiconductor substrate manufacturing method, the bonding step preferably comprises, after the step of bringing the first substrate having the non-porous layer into tight contact with the second substrate, the step of performing a process selected from the group consisting of anode bonding, pressing, heating, and a combination thereof.

According to still another aspect of the present invention, there is provided an anodizing apparatus for forming a porous layer on a substrate, characterized by comprising an anodizing bath having an anode and a cathode, a plurality of tanks for storing electrolytic solutions to be supplied to the anodizing bath, a supply mechanism for selectively supplying the electrolytic solution stored in any one of the plurality of tanks to the anodizing bath, and a drain mechanism for draining off the electrolytic solution from the anodizing bath back into the tank which supplied the electrolytic solution.

Preferably, the anodizing apparatus further comprises a holding mechanism for holding a conductive diaphragm between the anode and a substrate to be processed, and the conductive diaphragm prevents contamination of the substrate by the anode.

In the anodizing apparatus, the holding mechanism preferably holds the conductive diaphragm to flow a whole current from the anode to the substrate to be processed through the conductive diaphragm.

In the anodizing apparatus, the holding mechanism preferably holds the conductive diaphragm to cover a surface of the anode that opposes a backside surface of the substrate to be processed.

In the anodizing apparatus, the holding mechanism preferably holds the conductive diaphragm to isolate an electrolytic solution in contact with a surface of the substrate to be processed, that is on the anode side, from an electrolytic solution in contact with the anode.

In the anodizing apparatus, at least a surface of the conductive diaphragm that opposes the substrate to be processed is preferably formed from a silicon material.

In the anodizing apparatus, the holding mechanism preferably detachably holds the conductive diaphragm.

According to still another aspect of the present invention, there is provided an anodizing apparatus for forming a porous layer on a substrate, characterized by comprising at least two anodizing baths each having an anode and a cathode, and a conveyor mechanism for conveying a substrate anodized in one anodizing bath into the next anodizing bath.

In the other anodizing apparatus, the substrate is preferably anodized in all or some of the at least two anodizing baths under different conditions.

The other anodizing apparatus preferably further comprises a cleaning unit for cleaning the substrate processed in the final anodizing bath of the at least two anodizing baths, and a drier unit for drying the substrate cleaned by the cleaning unit.

In the other anodizing apparatus, preferably each of the anodizing baths comprises a holding mechanism for holding a conductive diaphragm between the anode and the substrate to be processed, and the conductive diaphragm prevents contamination of the substrate by the anode.

In the other anodizing apparatus, the holding mechanism preferably holds the conductive diaphragm to flow a whole current from the anode to the substrate to be processed through the conductive diaphragm.

In the other anodizing apparatus, the holding mechanism preferably holds the conductive diaphragm to cover a surface of the anode that opposes the substrate to be processed.

In the other anodizing apparatus, the holding mechanism preferably holds the conductive diaphragm to isolate an electrolytic solution in contact with a surface of the substrate to be processed, that is on the anode side, from an electrolytic solution in contact with the anode.

In the other anodizing apparatus, at least a surface of the conductive diaphragm that opposes the substrate to be processed is preferably formed from a silicon material.

In the other anodizing apparatus, the holding mechanism preferably detachably holds the conductive diaphragm.

Further objects, features and advantages of the present invention will become apparent from the following detailed description of embodiments of the present invention with reference to the accompanying drawings.

BRIEF DESCRIPTION OF THE DRAWINGS

Figs. 1A to 1F are views showing the steps of manufacturing a semiconductor substrate according to a preferred embodiment of the present invention;

Fig. 2 is a view showing the schematic arrangement of an anodizing apparatus according to the first embodiment;

Fig. 3 is a view showing the schematic arrangement of an anodizing apparatus according to the second embodiment;

Fig. 4 is a view showing the schematic arrangement of an anodizing apparatus according to the third embodiment;

Fig. 5 is a view showing a modification of the third embodiment;

Fig. 6 is a view showing an improved example of an anodizing bath shown in Fig. 5 which allows batch process of a number of substrates;

Fig. 7 is a view showing the schematic arrangement of an anodizing apparatus according to the fourth embodiment; and

Fig. 8 is a view showing the schematic arrangement of an automatic process line incorporating the anodizing apparatus shown in Fig. 7.

DETAILED DESCRIPTION OF THE PREFERRED EMBODIMENTS

Preferred embodiments of the present invention will be described below with reference to the accompanying drawings.

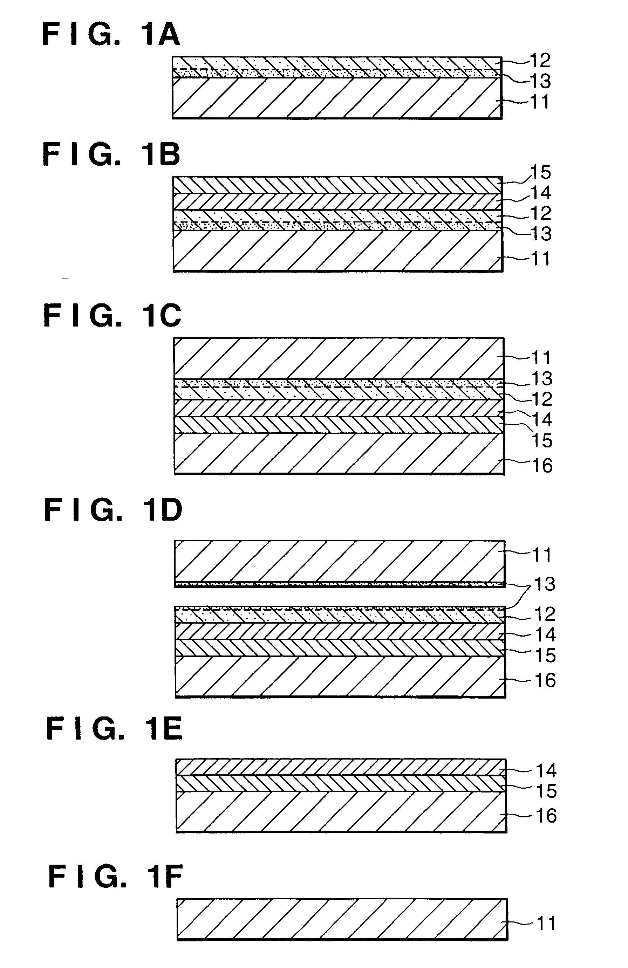

The steps of manufacturing a semiconductor substrate according to a preferred embodiment of the present invention will be described first. Figs. 1A to 1F are views showing the steps of manufacturing a semiconductor substrate according to this embodiment. In the step shown in Fig. 1A, a single-crystal Si substrate 11 is prepared, and two porous layers 12 and 13 having different porosities are formed on the upper surface side of the single-crystal Si substrate 11.

Three or more porous layers may be formed.

The uppermost porous layer 12 preferably has a low porosity of, e.g., 30% or less to form a high-quality epitaxial layer thereon. On the other hand, the second porous layer 13 preferably has a high porosity of, e.g., 30% or more to facilitate separation. The thickness of the porous layer 13 is preferably, e.g., 5 μm or less.

In the step shown in Fig. 1B, at least one non-porous layer is formed on the uppermost porous layer 12. The resultant structure is used as a first substrate. In the example shown in Fig. 1B, two non-porous layers 14 and 15 are formed. As the lower non-porous layer 14, for example, a single-crystal Si layer is suitable. This single-crystal Si layer can be used as an active layer. As the non-porous layer 15 on the upper surface side, for example, an $SiO_2$ layer is suitable. This $SiO_2$ layer is suitable to separate the active layer from the bonding interface.

As the non-porous layer, a polysilicon layer, an amorphous Si layer, a metal layer, a compound semiconductor layer, or a superconductor layer is also suitable. A device such as a MOSFET may be formed on the non-porous layer at this time point.

In the step shown in Fig. 1C, the first substrate and an independently prepared second substrate 16 are brought into tight contact with each other at room temperature while sandwiching the non-porous layers. After this, the first and second substrates are bonded by anode bonding, pressing, heating, or a combination thereof.

When a single-crystal Si layer is formed as the non-porous layer 14, the first and second substrates are preferably bonded after an $SiO_2$ layer is formed on the surface of the single-crystal Si layer by, e.g., thermal oxidation, as described above.

As the second substrate, an Si substrate having an $SiO_2$ layer formed thereon, a transparent substrate consisting of silica glass, quartz or a sapphire wafer is suitably used in addition to the Si substrate. However, the second substrate is not limited to this, and any other substrate can be used as far as it has a sufficiently flat surface to be bonded.

When the non-porous layer 14 is not formed from Si, or no Si substrate is used as the second substrate 16, the non-porous layer 15 as an insulating layer need not be formed.

In bonding, another insulating thin plate may be inserted between the first and second substrates to form a three-layered structure.

In the step shown in Fig. 1D, the bonded substrate stack is separated into two substrates at the porous layer 13. To separate the bonded substrate stack, for example, a fluid such as water is injected between the substrates, a pressure is applied, an external pressure such as a tensile or shearing force is applied, the porous Si layer 13 is oxidized to expand from the peripheral portion to generate an internal pressure in the porous Si layer 13, thermal stress is applied to the porous layer 13 by heat changing in a pulse shape, or the porous layer 13 is softened. Any other methods can also be employed.

In the step shown in Fig. 1E, the porous layers 12 and 13 on the second substrate 16 are removed. When the non-porous layer 14 is a single-crystal Si layer, only the porous Si layers 12 and 13 are etched by electroless wet chemical etching using at least one etchant selected from a normal etchant for etching Si, hydrofluoric acid as an etchant for selectively etching porous Si, a mixed solution prepared by adding at least one of an alcohol and hydrogen peroxide to hydrofluoric acid, buffered hydrofluoric acid, or a mixed solution prepared by adding at least one of an alcohol and hydrogen peroxide to buffered hydrofluoric acid, thereby leaving the non-porous layers 14 and 15 on the second substrate 16. Since the non-porous Si layer has a large surface area, only porous Si can be selectively etched even by a normal Si etchant, as described above.

Alternatively, the porous Si layers 12 and 13 may be selectively removed by polishing using the non-porous layer 14 as a polishing stopper.

When a compound semiconductor layer is formed as the non-porous layer 14, only the porous Si layers 12 and 13 can be selectively chemically etched using an etchant whose etching rate for Si is higher than that for a compound semiconductor to leave a thin single-crystal compound semiconductor layer (non-porous layer 14) on the second substrate 16. Alternatively, the porous Si layers 12 and 13 may be selectively removed by polishing using the single-crystal compound semiconductor layer (non-porous layer 14) as a polishing stopper.

Fig. 1E shows the semiconductor substrate manufactured by the above steps. According to the above steps, a flat non-porous thin film (e.g., a single-crystal Si thin film) having a uniform thickness can be formed in the entire region of the second substrate 16.

For example, a semiconductor substrate having a single-crystal Si layer as the surface-side non-porous layer 14 and an $SiO_2$ layer as the inner non-porous layer 15 can be used as an SOI substrate. When an insulating substrate is used as the second substrate 16, a semiconductor substrate suitable for forming an electrically insulated electronic element can be manufactured.

In the step shown in Fig. 1F, the porous layer 13 left on the first substrate side, i.e., on the single-crystal Si substrate 11 is removed. If the surface planarity falls outside the allowable range, the surface of the single-crystal Si substrate 11 is planarized. With this process, this substrate can be used as a substrate (single-crystal Si substrate 11) for forming a first substrate, or the second substrate 16.

Embodiments of an anodizing apparatus for performing the step shown in Fig. 1A, i.e., forming a porous layer having a multilayered structure will be described below.

[First Embodiment]

In an anodizing apparatus of this embodiment, every time one porous layer is formed, the electrolytic solution in an anodizing bath is exchanged to change the anodizing conditions, thereby forming a porous layer having a multilayered structure.

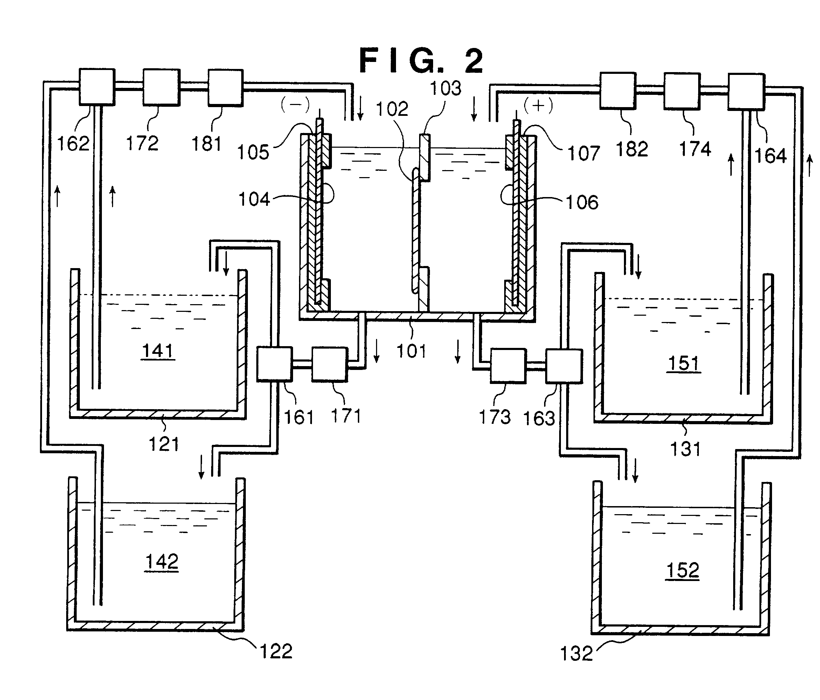

Fig. 2 is a view showing the schematic arrangement of the anodizing apparatus according to the first embodiment. This anodizing apparatus comprises an anodizing bath 101, solution tanks 121, 122, 131, and 132, and solution supply and removal mechanisms.

The anodizing bath 101 has a cathode (consisting of, e.g., platinum) 104, a cathode holder 105 fixing the cathode 104 in the bath, an anode (consisting of, e.g., platinum) 106, an anode holder 107 fixing the anode 106 in the bath, and a substrate holder 103 for fixing an Si substrate 102 to be processed between the pair of electrodes 104 and 106. The substrate holder 103 has an opening portion for bringing the lower surface of the substrate 102 to be processed into contact with the portion of an electrolytic solution on the anode 106 side.

In the anodizing bath 101, the cathode 104 side of the Si substrate 102 to be processed, i.e., the side on which a porous layer is formed on the Si substrate 102 is isolated from the anode 106 side of the Si substrate 102 when the Si substrate 102 is set on the substrate holder 103.

The cathode side of the anodizing bath 101 is filled with an electrolytic solution in the tank 121 or 122. The anode side is filled with an electrolytic solution in the tank 131 or 132.

The electrolytic solution filling the cathode side of the anodizing bath 101 and that filling the anode side may be the same electrolytic solution or different electrolytic solutions. As the electrolytic solution filling the cathode side of the anodizing bath 101, an electrolytic solution essential for anodizing, i.e., an electrolytic solution containing HF must be used. However, the electrolytic solution filling the anode side need only have an appropriate conductivity. To prevent any adverse influence resulting from mixing of the electrolytic solution on the cathode side with that on the anode side, the two electrolytic solutions are preferably of the same type.

A description will be made below assuming that first electrolyte solutions 141 and 151 are stored in the first and second tanks 121 and 131, respectively, and first electrolyte solutions 142 and 152 different from the first electrolytic solution are stored in the third and fourth tanks 122 and 132, respectively. Different electrolytic solutions mean electrolytic solutions having different mixing ratios of chemical substances or electrolytic solutions having different compositions.

In this anodizing apparatus, first, the Si substrate 102 is anodized using the first electrolyte solutions 141 and 151 to form a first porous layer. Subsequently, the Si substrate 102 is anodized using the second electrolyte solutions 142 and 152 to form a second porous layer.

The flow of process by the anodizing apparatus will be described below in detail.

First, the electrolytic solution in the anodizing bath 101 is drained off, and valves 161 and 163 are closed. In this state, the Si substrate 102 to be processed is conveyed to the substrate holder 103 by an automatic conveyor robot or the like and fixed by a vacuum chuck mechanism (not shown) by chucking.

A valve 162 is opened to the first tank 121 side. The first electrolyte solution 141 is pumped up by a pump 172 and supplied to the cathode side of the anodizing bath 101 through a filter 181. Simultaneously, a valve 164 is opened to the second tank 131 side. The first electrolyte solution 151 is pumped up by a pump 174 and supplied to the anode side of the anodizing bath 101 through a filter 182.

When the cathode and anode sides of the anodizing bath 101 are filled with the first electrolyte solutions 141 and 151, respectively, a current having a first current value is flowed across the cathode 104 and the anode 106 for a predetermined time to anodize the Si substrate 102, thereby forming a first porous layer on the cathode side of the Si substrate 102.

Subsequently, to exchange the first electrolytic solutions in the anodizing bath 101 with the second electrolytic solutions, the valve 161 is opened to the first tank 121 side. The first electrolyte solution is drained off by a pump 171 from the lower portion of the anodizing bath 101 on the cathode side into the first tank 121, and the valve 161 is closed. Simultaneously, the valve 163 is opened to the second tank 131 side. The first electrolyte solution is drained off by a pump 173 from the lower portion of the anodizing bath 101 on the anode side into the second tank 131, and the valve 163 is closed.

Next, the valve 162 is opened to the third tank 122 side. The second electrolyte solution 142 is pumped up by the pump 172 and supplied to the cathode side of the anodizing bath 101 through the filter 181. Simultaneously, the valve 164 is opened to the fourth tank 132 side. The second electrolyte solution 152 is pumped up by the pump 174 and supplied to the anode side of the anodizing bath 101 through the filter 182. The interior of the anodizing bath 101 is preferably cleaned by a cleaning solution such as water before the second electrolyte solutions 142 and 152 are supplied to the anodizing bath 101. Upon completing cleaning, the cleaning solution is preferably completely drained off from the anodizing bath 101 to prevent any adverse influence on the electrolytic solutions to be supplied next.

When the cathode and anode sides of the anodizing bath 101 are filled with the second electrolyte solutions 142 and 152, respectively, a current having a second current value is flowed across the cathode 104 and the anode 106 for a predetermined time to anodize the Si substrate 102, thereby forming a second porous layer on the cathode side of the Si substrate 102. The second porous layer is formed on the lower side of the first porous layer.

The valve 161 is opened to the third tank 122 side. The second electrolyte solution is drained off by the pump 171 from the lower portion of the anodizing bath 101 on the cathode side into the third tank 122, and the valve 161 is closed. Meanwhile, the valve 163 is opened to the fourth tank 132 side. The second electrolyte solution is drained off by the pump 173 from the lower portion of the anodizing bath 101 on the anode side into the fourth tank 132, and the valve 163 is closed. After the second electrolyte solutions 142 and 152 are drained off, the interior of the anodizing bath 101 is preferably cleaned by a cleaning solution such as water. Upon completing cleaning, the cleaning solution is preferably completely drained off from the anodizing bath 101 to prevent any adverse influence on the electrolytic solutions to be supplied next.

After formation of the second porous layer, a third porous layer may be formed by filling the anodizing bath 101 with the first electrolyte solutions 141 and 151 again or another electrolytic solution. More porous layers may be formed by repeating this process.

[Second Embodiment]

An anodizing apparatus of this embodiment has a plurality of anodizing baths. With this arrangement, every time one porous layer is formed, the anodizing bath is exchanged, thereby forming a porous layer having a multilayered structure.

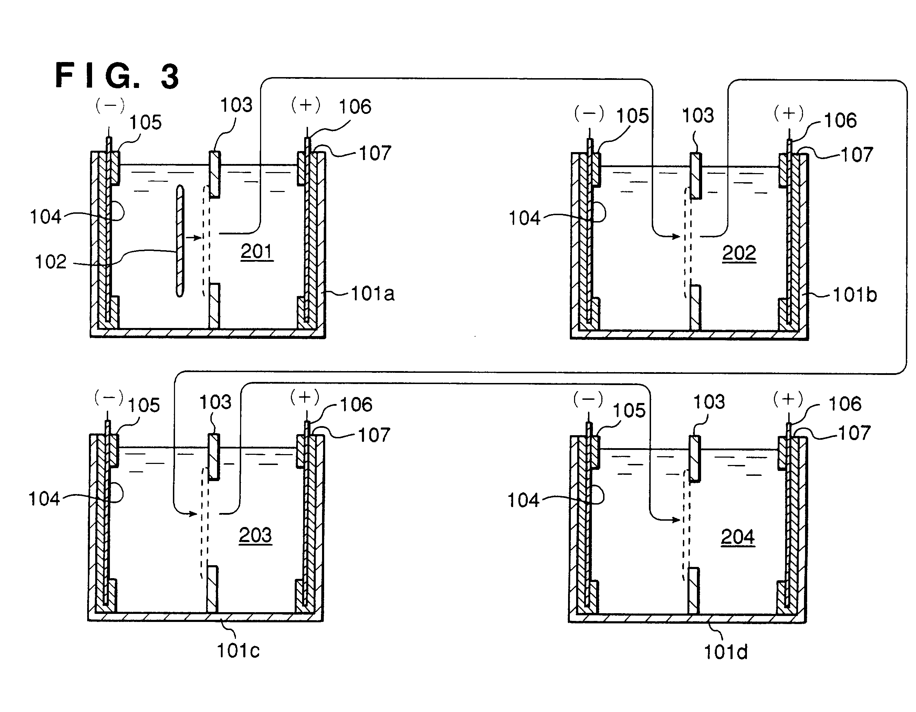

Fig. 3 is a view showing the schematic arrangement of the anodizing apparatus according to the second embodiment. This anodizing apparatus is used to form a porous layer having a four-layered structure and comprises four anodizing baths 101a, 101b, 101c, and 101d. Each of the anodizing baths 101a, 101b, 101c, and 101d substantially has the same arrangement as that of the anodizing bath 101 shown in Fig. 2 and comprises a pair of electrodes 104 and 106 and a substrate holder 103.

The anodizing baths 101a, 101b, 101c, and 101d are filled with first, second, third, and fourth first electrolyte solutions 201, 202, 203, and 204, respectively. The third electrolyte solution 203 may be the same as the first electrolyte solution 201. The fourth electrolyte solution 204 may be the same as the first or second electrolyte solution 201 or 202.

According to this anodizing apparatus, after an Si substrate 102 is processed in one anodizing bath, the Si substrate 102 is transferred to another anodizing bath filled with a different electrolytic solution to change the anodizing conditions, and the next process is executed. Hence, the electrolytic solution need not be exchanged every time one porous layer is formed. In addition, since a free anodizing bath can be used to process the next Si substrate 102, high throughput can be realized.

More specifically, first, the Si substrate 102 is set on the substrate holder 103 of the first anodizing bath 101a filled with the first electrolyte solution 201 and anodized under the first conditions. Subsequently, the Si substrate 102 is set on the substrate holder 103 of the second anodizing bath 101b filled with the second electrolyte solution 202, and anodized under the second conditions. Then, the Si substrate 102 is set on the substrate holder 103 of the third anodizing bath 101c filled with the third electrolyte solution 203 and anodized under the third conditions. Finally, the Si substrate 102 is set on the substrate holder 103 of the fourth anodizing bath 101d filled with the fourth electrolyte solution 204 and anodized under the fourth conditions.

[Third Embodiment]

This embodiment is an improvement of the anodizing apparatus of the first embodiment. In the anodizing apparatus according to the third embodiment, an Si substrate 102 to be processed is prevented from being contaminated by the metal material (e.g., platinum) of an anode, which is dissolved into an electrolytic solution.

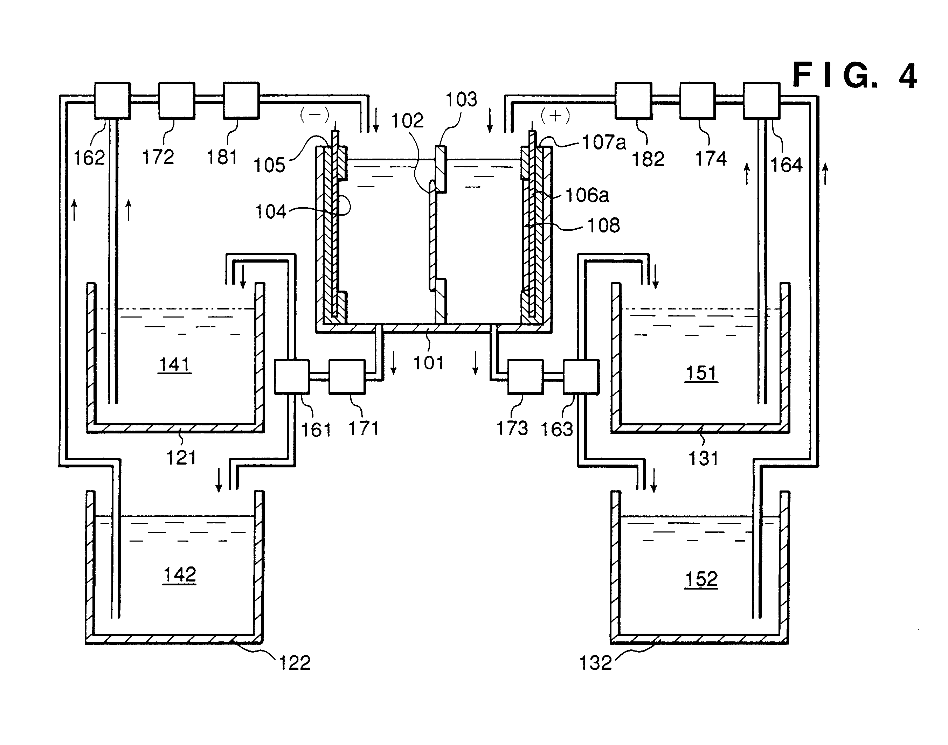

Fig. 4 is a view showing the schematic arrangement of the anodizing apparatus according to the third embodiment.

In this anodizing apparatus, a conductive diaphragm 108 for preventing contamination of the electrolytic solution and the Si substrate 102 to be processed is inserted between an anode 106a and the electrolytic solution. This conductive diaphragm 108 is preferably comprised of an Si substrate and, more specifically, an Si substrate having almost the same resistivity as that of the Si substrate 102 to be processed. When the conductive diaphragm 108 is formed from the same material as that of the Si substrate 102 to be processed, the Si substrate 102 to be processed can be prevented from being contaminated.

The conductive diaphragm 108 is preferably detachable. In the example shown in Fig. 4, for example, a vacuum chuck mechanism is preferably arranged on the surface of the anode 106a or in an anode holder 107a. The conductive diaphragm 108 and anode 106a need be electrically connected. When a gap is formed between the conductive diaphragm 108 and the anode 106a, the gap must be filled with a conductive solution or a conductive material.

When an Si substrate is to be processed using this anodizing apparatus, the conductive diaphragm 108 is set on the anode holder 107a, and then, an anodizing bath 101 is filled with first electrolyte solutions 141 and 151 to process the Si substrate 102. After this, the Si substrate 102 may be processed after exchanging the first electrolyte solutions 141 and 151 with second electrolyte solutions 142 and 152 without exchanging the conductive diaphragm 108.

However, for example, when an Si substrate of the same type as the Si substrate to be processed is used as the conductive diaphragm, and an electrolytic solution (e.g., a solution containing HF) is used as the electrolytic solutions 151 and 152 filling the anode 106a side, the conductive diaphragm is preferably exchanged with a diaphragm dedicated to each electrolytic solution every time the electrolytic solution is exchanged. The reason for this is as follows.

When the space between the Si substrate 102 to be processed and the conductive diaphragm 108 is filled with an electrolytic solution such as a solution containing HF, and anodizing is performed, a porous layer is formed not only on the cathode side of the Si substrate 102 to be processed but also on the cathode side of the conductive diaphragm 108. When the process of forming a porous layer having a multilayered structure while changing the anodizing conditions is repeated for the number of Si substrates 102, a thick multilayered structure of a number of porous layers with different porosities is formed on the conductive diaphragm 108. Finally, the porous layers break to contaminate the interior of the bath or Si substrate to be processed. The probable causes for break of the porous layers on the conductive diaphragm 108 are as follows.

1) Since porous layers having different porosities are stacked, the pore walls cannot withstand stress.

2) When a porous layer having a high porosity is formed under (inside) a porous layer having a low porosity, the porosity of the porous layer with a high porosity increases in proportion to the depth from the surface of the conductive diaphragm 108 to the porous layer (the total thickness of the porous layers). Hence, when a number of Si substrates are processed, the porosity of the porous layer formed at the deepest portion of the conductive diaphragm 108 reaches the critical value to break the pore walls.

Break of pore walls hardly occurs when anodizing is repeated under the same condition. This is because a nearly constant porosity is maintained in the direction of depth of the conductive diaphragm 108.

A suitable process procedure of forming a porous layer using this anodizing apparatus will be described below. In this case, assume that a porous layer having a multilayered structure is to be formed on each of 25 Si substrates.

First, the electrolytic solution in the anodizing bath 101 is drained off, and valves 161 and 163 are closed. In this state, the conductive diaphragm 108 for the first electrolyte solution 151 is conveyed and fixed on the anode holder 107a by an automatic conveyor robot or the like.

The first Si substrate 102 to be processed is conveyed and fixed on a substrate holder 103 by an automatic conveyor robot or the like.

A valve 162 is opened to the first tank 121 side. The first electrolyte solution 141 is pumped up by a pump 172 and supplied to the cathode side of the anodizing bath 101 through a filter 181. Simultaneously, a valve 164 is opened to the second tank 131 side. The first electrolyte solution 151 is pumped up by a pump 174 and supplied to the anode side of the anodizing bath 101 through a filter 182.

When the cathode and anode sides of the anodizing bath 101 are filled with the first electrolyte solutions 141 and 151, respectively, a current having a first current value is flowed across a cathode 104 and the anode 106a for a predetermined time to anodize the first Si substrate 102, thereby forming a first porous layer on the cathode side of the Si substrate 102.

The valve 161 is opened to the first tank 121 side. The first electrolyte solution is drained off by a pump 171 from the lower portion of the anodizing bath 101 on the cathode side into the first tank 121, and the valve 161 is closed. In the mean time, the valve 163 is opened to the second tank 131 side. The first electrolyte solution is drained off by a pump 173 from the lower portion of the anodizing bath 101 on the anode side into the second tank 131, and the valve 163 is closed.

The first Si substrate 102 fixed on the substrate holder 103 is exchanged with the second Si substrate 102.

The valve 162 is opened to the first tank 121 side. The first electrolyte solution 141 is pumped up by the pump 172 and supplied to the cathode side of the anodizing bath 101 through the filter 181. Also, the valve 164 is opened to the second tank 131 side. The first electrolyte solution 151 is pumped up by the pump 174 and supplied to the anode side of the anodizing bath 101 through the filter 182.

When the cathode and anode sides of the anodizing bath 101 are filled with the first electrolyte solutions 141 and 151, respectively, a current having a first current value is flowed across the cathode 104 and the anode 106a for a predetermined time to anodize the second Si substrate 102, thereby forming a first porous layer on the cathode side of the Si substrate 102.

This process is repeated until the 25th Si substrate 102.

Subsequently, to exchange the first electrolytic solutions in the anodizing bath 101 with the second electrolytic solutions, the valve 161 is opened to the first tank 121 side. The first electrolyte solution is drained off by the pump 171 from the lower portion of the anodizing bath 101 on the cathode side into the first tank 121, and the valve 161 is closed.

Simultaneously, the valve 163 is opened to the second tank 131 side. The first electrolyte solution is drained off by the pump 173 from the lower portion of the anodizing bath 101 on the anode side into the second tank 131, and the valve 163 is closed.

The conductive diaphragm 108 for the second electrolyte solution 152 is conveyed and fixed on the anode holder 107a by an automatic conveyor robot or the like.

Next, the valve 162 is opened to the third tank 122 side. The second electrolyte solution 142 is pumped up by the pump 172 and supplied to the cathode side of the anodizing bath 101 through the filter 181.

Simultaneously, the valve 164 is opened to the fourth tank 132 side. The second electrolyte solution 152 is pumped up by the pump 174 and supplied to the anode side of the anodizing bath 101 through the filter 182. The interior of the anodizing bath 101 is preferably cleaned by a cleaning solution such as water before the second electrolyte solutions 142 and 152 are supplied to the anodizing bath 101. Upon completing cleaning, the cleaning solution is preferably completely drained off from the anodizing bath 101 to prevent any adverse influence on the electrolytic solutions to be supplied next.

When the cathode and anode sides of the anodizing bath 101 are filled with the second electrolyte solutions 142 and 152, respectively, a current having a second current value is flowed across the cathode 104 and the anode 106a for a predetermined time to anodize the Si substrate 102, thereby forming a second porous layer on the cathode side of the Si substrate 102. The second porous layer is formed on the lower side of the first porous layer.

The valve 161 is opened to the third tank 122 side. The second electrolyte solution is drained off by the pump 171 from the lower portion of the anodizing bath 101 on the cathode side into the third tank 122, and the valve 161 is closed. At the same time, the valve 163 is opened to the fourth tank 132 side. The second electrolyte solution is drained off by the pump 173 from the lower portion of the anodizing bath 101 on the anode side into the fourth tank 132, and the valve 163 is closed.

The first Si substrate 102 fixed on the substrate holder 103 is exchanged with the second Si substrate 102.

Next, the valve 162 is opened to the third tank 122 side. The second electrolyte solution 142 is pumped up by the pump 172 and supplied to the cathode side of the anodizing bath 101 through the filter 181.

Simultaneously, the valve 164 is opened to the fourth tank 132 side. The second electrolyte solution 152 is pumped up by the pump 174 and supplied to the anode side of the anodizing bath 101 through the filter 182.

When the cathode and anode sides of the anodizing bath 101 are filled with the second electrolyte solutions 142 and 152, respectively, a current having a second current value is flowed across the cathode 104 and the anode 106a for a predetermined time to anodize the Si substrate 102, thereby forming a second porous layer on the cathode side of the Si substrate 102.

This process is repeated until the 25th Si substrate 102.

Finally, the valve 161 is opened to the third tank 122 side. The second electrolyte solution is drained off by the pump 171 from the lower portion of the anodizing bath 101 on the cathode side into the third tank 122, and the valve 161 is closed. Also, the valve 163 is opened to the fourth tank 132 side. The second electrolyte solution is drained off by the pump 173 from the lower portion of the anodizing bath 101 on the anode side into the fourth tank 132, and the valve 163 is closed. After the second electrolyte solutions 142 and 152 are drained off, the interior of the anodizing bath 101 is preferably cleaned by a cleaning solution such as water. Upon completing cleaning, the cleaning solution is preferably completely drained off from the anodizing bath 101 to prevent any adverse influence on the electrolytic solutions to be supplied next.

In the above series of processes, every time the Si substrate 102 is exchanged, the electrolytic solutions are temporarily drained off from the anodizing bath 101. However, when electrolytic solutions of the same type are supplied to both the cathode and anode sides of the anodizing bath 101 and, especially, when corrosion of the automatic conveyor robot for conveying the Si substrate 102 need not be taken into consideration, the Si substrate 102 can be exchanged while keeping the anodizing bath 101 filled with electrolytic solutions.

After formation of the second porous layer, a third porous layer may be formed by filling the anodizing bath 101 with the first electrolyte solutions 141 and 151 again or another electrolytic solution. More porous layers may be formed by repeating this process.

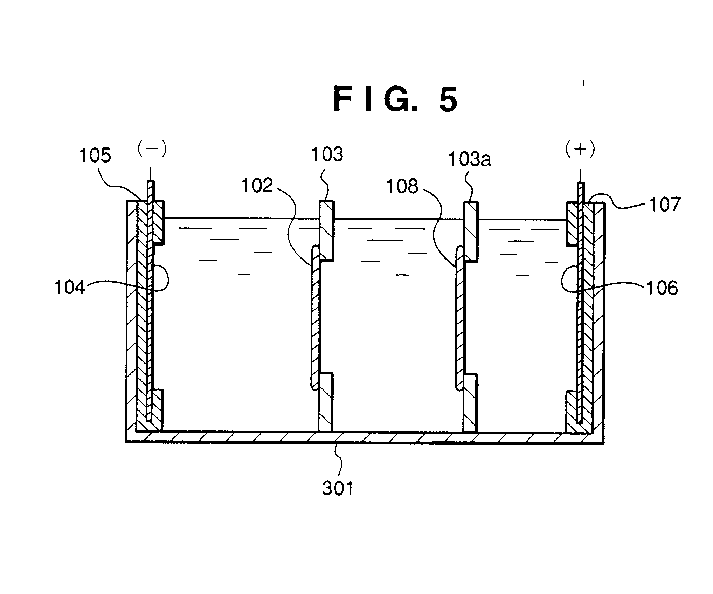

Fig. 5 is a view showing a modification of the third embodiment. An anodizing bath 301 shown in Fig. 5 has a conductive diaphragm holder 103a exclusively used to hold the conductive diaphragm 108 in place. The anodizing bath 301 is used while filling the gap between the conductive diaphragm 108 and the anode 106 with a conductive solution. This conductive solution is used to simply electrically connect the conductive diaphragm 108 and anode 106 and therefore need not be exchanged every time a porous layer having a multilayered structure is formed on the Si substrate 102 to be processed. The anodizing bath 301 is replaced with, e.g., the anodizing bath 101 shown in Fig. 4.

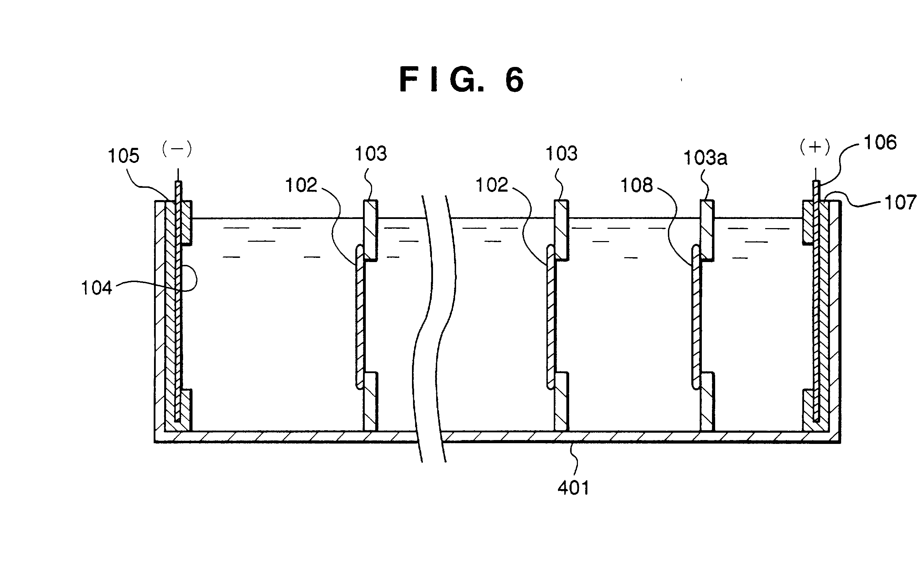

Fig. 6 is a view showing an improvement example of the anodizing bath shown in Fig. 5 which allows batch process of a number of substrates. An anodizing bath 401 has a plurality of substrate holders 103.

In this embodiment, the conductive diaphragm and Si substrate to be processed are electrically connected by filling the gap therebetween with a conductive solution. However, the conductive diaphragm and Si substrate to be processed may be brought into direct contact with each other.

[Fourth Embodiment]

This embodiment is an improvement of the anodizing apparatus of the second embodiment. The anodizing apparatus according to the fourth embodiment has a means for preventing an Si substrate 102 to be processed from being contaminated by the metal material (e.g., platinum) of an anode 106a, which is dissolved into an electrolytic solution.

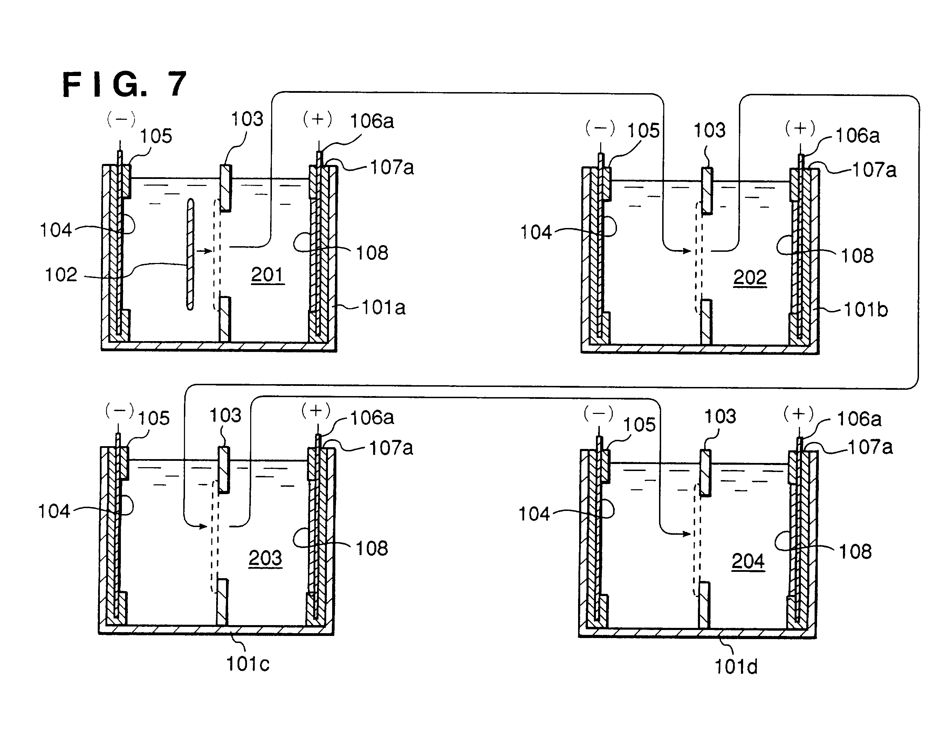

Fig. 7 is a view showing the schematic arrangement of the anodizing apparatus according to the fourth embodiment.

In this anodizing apparatus, a conductive diaphragm 108 for preventing contamination of the electrolytic solution and the Si substrate 102 to be processed is inserted between the anode 106a and the electrolytic solution. This conductive diaphragm 108 is preferably comprised of an Si substrate and, more specifically, an Si substrate having almost the same resistivity as that of the Si substrate 102 to be processed. When the conductive diaphragm 108 is formed from the same material as that of the Si substrate 102 to be processed, the Si substrate 102 to be processed can be prevented from being contaminated.

The conductive diaphragm 108 is preferably detachable. In the example shown in Fig. 7, for example, a vacuum chuck mechanism is preferably disposed on the surface of the anode 106a or in an anode holder 107a. The conductive diaphragm 108 and anode 106a need be electrically connected. When a gap is formed between the conductive diaphragm 108 and the anode 106a, the gap must be filled with a conductive solution or a conductive material.

The anodizing apparatus of this embodiment has a plurality of anodizing baths. With this arrangement, every time one porous layer is formed, the anodizing bath is exchanged, thereby forming a porous layer having a multilayered structure. Since anodizing can be executed under the same conditions in each anodizing bath, the problem described in the third embodiment, i.e., the problem of break of the conductive diaphragm 108 need not be taken into consideration. Since the conductive diaphragm 108 need not be frequently exchanged, this anodizing apparatus is excellent in throughput.

The process procedure by this anodizing apparatus is the same as in the second embodiment.

Each of first anodizing baths 101a, 101b, 101c, and 101d of the anodizing apparatus of this embodiment may be replaced with the anodizing bath 301 shown in Fig. 5 or anodizing bath 401 shown in Fig. 6.

In this embodiment, the conductive diaphragm and Si substrate to be processed are electrically connected by filling the gap therebetween with a conductive solution. However, the conductive diaphragm and Si substrate to be processed may be brought into direct contact with each other.

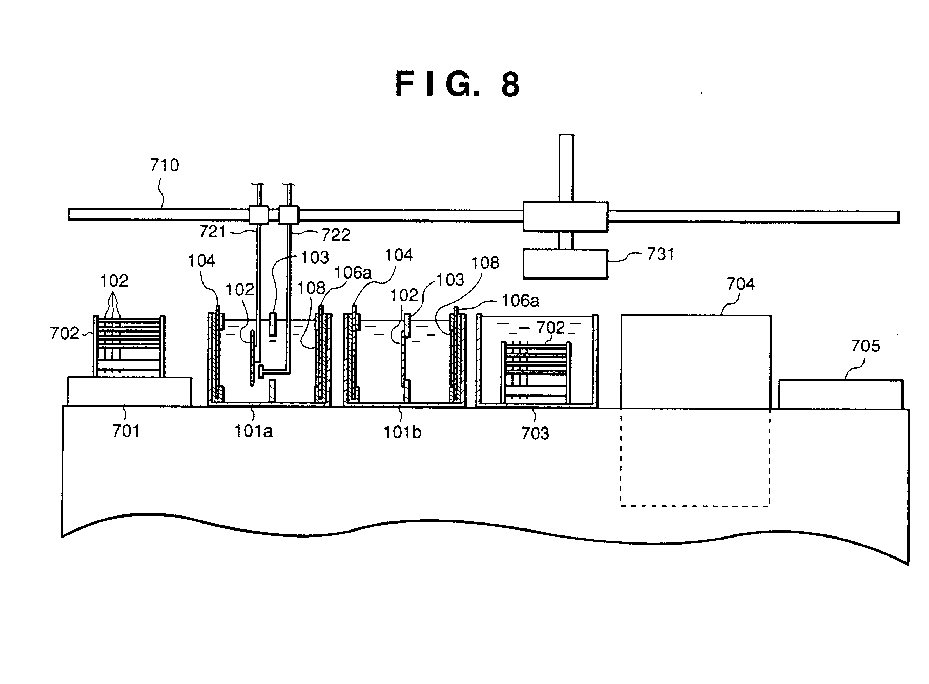

Fig. 8 is a view showing the schematic arrangement of an automatic process line incorporating the anodizing apparatus shown in Fig. 7. This automatic manufacturing line has two anodizing baths 101a and 101b for forming a porous layer having a two-layered structure. Three or more anodizing baths may also be used, as a matter of course.

The process procedure by this automatic manufacture line will be described below.

A wafer carrier 702 storing Si substrates 102 to be processed is mounted on a loader 701. The start of the process is instructed by operating a control panel (not shown).

In response to this, a first conveyor robot 721 extracts one Si substrate 102 from the wafer carrier 702 by chucking it from the lower surface and dips it into the first anodizing bath 101a on the cathode 104 side. A second conveyor robot 722 receives the Si substrate 102 by chucking it from the lower surface and moves the Si substrate 102 to a position where the Si substrate 102 comes into contact with the chuck surface of a substrate holder 103. In this state, the vacuum chuck mechanism of the substrate holder 103 is activated to chuck the Si substrate 102 on the chuck surface.

A predetermined current is flowed across the electrodes 104 and 106a of the first anodizing bath 101a, thereby forming a first porous layer on the surface of the Si substrate 102.

After the second conveyor robot 722 chucks the Si substrate 102 in the first anodizing bath 101a by chucking it from the lower surface, and vacuum chuck by the substrate holder 103 is canceled, the Si substrate 102 is separated from the substrate holder 103. The Si substrate 102 is transferred from the second conveyor robot 722 to the first conveyor robot 721.

The Si substrate 102 is conveyed to the second anodizing bath 101b by the first conveyor robot 721, transferred to the second conveyor robot 722, and set on the substrate holder 103 of the second anodizing bath 101b.

A predetermined current is flowed across the electrodes 104 and 106a of the second anodizing bath 101b, thereby forming a second porous layer under the first porous layer on the Si substrate 102.

After the second conveyor robot 722 chucks the Si substrate 102 in the second anodizing bath 101b by chucking it from the lower surface, and vacuum chuck by the substrate holder 103 is canceled, the Si substrate 102 is separated from the substrate holder 103. The Si substrate 102 is transferred from the second conveyor robot 722 to the first conveyor robot 721.

The Si substrate 102 is stored by the first conveyor robot 721 in the wafer carrier 702 which has been dipped into a washing tank 703 in advance.

The above process is continuously executed to process all the Si substrates 102 in the wafer carrier 702 on the loader 701 and store them in the wafer carrier 702 in the washing tank 703. After this, the Si substrates 102 are cleaned.

Finally, a third conveyor robot 731 extracts the Si substrates 102 in the washing bath 703 while keeping them stored in the wafer carrier 702 and conveys them to a spin drier 704. After the Si substrates 102 are dried by the spin drier 704, the third conveyor robot 731 conveys the Si substrates 102 onto an unloader 705 while keeping them stored in the wafer carrier 702.

Examples of anodizing by the above anodizing apparatuses will be described next.

[Example 1]

A single-crystal Si substrate was set in each of the anodizing apparatuses of the above embodiments, and a porous layer having a two-layered structure was formed. The first and second anodizing conditions were as follows.

| <First Anodizing Conditions> | |
| --- | --- |
| Current density | 7 (mA.cm$^{-2}$) |
| Anodizing solution | HF : H$_2$O : C$_2$H$_5$OH = 1 : 1 : 1 |
| Process time | 11 (min) |
| Thickness of porous Si layer (target) | 12 ($\mu$m) |
| Porosity (target) | to 24% |

| <Second Anodizing Conditions> | |
| --- | --- |
| Current density | 10 (mA.cm$^{-2}$) |
| Anodizing solution | HF : H$_2$O : C$_2$H$_5$OH = 1 : 2 : 2 |
| Process time | 3 (min) |
| Thickness of porous Si layer (target) | 3 ($\mu$m) |
| Porosity (target) | to 35% |

In each of the anodizing apparatuses of the first to fourth embodiments, a substrate having a porous layer with a two-layered structure could be manufactured. In each of the apparatuses of the second and fourth anodizing apparatuses, two anodizing baths were used.

In the anodizing apparatus of the third embodiment, after a first porous layer was formed on each of 25 Si substrates, the electrolytic solutions and conductive diaphragm were exchanged, and a second porous layer was formed on each of the 25 Si substrates. Porous layers sequentially formed on each Si substrate used as the conductive diaphragm did not break.

In the anodizing apparatus of the fourth embodiment, first and second porous layers were sequentially formed on each of 25 Si substrates. Porous layers sequentially formed on each Si substrate used as the conductive diaphragm did not break.

[Example 2]

A single-crystal Si substrate was set in each of the anodizing apparatuses of the above embodiments, and a porous layer having a three-layered structure was formed. The first to third anodizing conditions were as follows.

| <First Anodizing Conditions> | |
| --- | --- |
| Current density | 7 (mA.cm$^{-2}$) |
| Anodizing solution | HF : H$_2$O : C$_2$H$_5$OH = 1 : 1 : 1 |

(continued)

| <First Anodizing Conditions> | |
| --- | --- |
| Process time | 11 (min) |
| Thickness of porous Si layer (target) | 12 ($\mu$m) |
| Porosity (target) | to 24% |

| <Second Anodizing Conditions> | |
| --- | --- |
| Current density | 10 (mA.cm$^{-2}$) |
| Anodizing solution | HF : $H_2O$ : $C_2H_5OH$ = 1 : 2 : 2 |
| Process time | 3 (min) |
| Thickness of porous Si layer (target) | 3 ($\mu$m) |
| Porosity (target) | to 35% |

| <Third Anodizing Conditions> | |
| --- | --- |
| Current density | 7 (mA.cm$^{-2}$) |
| Anodizing solution | HF : $H_2O$ : $C_2H_5OH$ = 1 : 1 : 1 |
| Process time | 1 (min) |
| Thickness of porous Si layer (target) | 1.1 ($\mu$m) |
| Porosity (target) | to 25% |

In each of the anodizing apparatuses of the first to fourth embodiments, a substrate having a porous layer with a three-layered structure could be manufactured. In each of the anodizing apparatuses of the first and third embodiments, the anodizing solution for the first and third anodizing processes was supplied from the first and second tanks, and the anodizing solution for the second anodizing process was supplied from the third and fourth tanks. In each of the anodizing apparatuses of the second and fourth embodiments, three anodizing baths were used.

In the anodizing apparatus of the third embodiment, a first conductive diaphragm was set, and a first porous layer was formed on each of 25 Si substrates under the first anodizing conditions. Subsequently, a second conductive diaphragm was set, and a second porous layer was formed on each of the 25 Si substrates under the second anodizing conditions. Then, a third conductive diaphragm was set, and a third porous layer was formed on each of the 25 Si substrates under the third anodizing conditions. Porous layers sequentially formed on each Si substrate used as the conductive diaphragm did not break.

In the anodizing apparatus of the fourth embodiment, first to third porous layers were sequentially formed on each of 25 Si substrates. Porous layers sequentially formed on each Si substrate used as the conductive diaphragm did not break.

[Example 3]

A single-crystal Si substrate was set in each of the anodizing apparatuses of the above embodiments, and a porous layer having a two-layered structure was formed. The first and second anodizing conditions were as follows.

| <First Anodizing Conditions> | |
| --- | --- |
| Current density | 7 (mA.cm$^{-2}$) |
| Anodizing solution | HF : $H_2O$ : $C_2H_5OH$ = 1 : 1 : 1 |
| Process time | 5 (min) |
| Thickness of porous Si layer (target) | 6 ($\mu$m) |
| Porosity (target) | to 24% |

| <Second Anodizing Conditions> | |
| --- | --- |
| Current density | 30 (mA.cm$^{-2}$) |

(continued)

| <Second Anodizing Conditions> | |
|---|---|
| Anodizing solution | HF : $H_2O$ : $C_2H_5OH$ = 1 : 1 : 1 |
| Process time | 110 (sec) |
| Thickness of porous Si layer (target) | 3 ($\mu$m) |
| Porosity (target) | to 40% |

In each of the anodizing apparatuses of the first to fourth embodiments, a substrate having a porous layer with a two-layered structure could be manufactured. In each of the apparatuses of the second and fourth anodizing apparatuses, two anodizing baths were used.

In the anodizing apparatus of the third embodiment, after a first porous layer was formed on each of 25 Si substrates, the electrolytic solutions and conductive diaphragm were exchanged, and a second porous layer was formed on each of the 25 Si substrates. Porous layers sequentially formed on each Si substrate used as the conductive diaphragm did not break.

In the anodizing apparatus of the fourth embodiment, first and second porous layers were sequentially formed on each of 25 Si substrates. Porous layers sequentially formed on each Si substrate used as the conductive diaphragm did not break.

[Example 4]

A single-crystal Si substrate was set in each of the anodizing apparatuses of the above embodiments, and a porous layer having a two-layered structure was formed. The first and second anodizing conditions were as follows.

| <First Anodizing Conditions> | |
|---|---|
| Current density | 7 (mA.cm$^2$) |
| Anodizing solution | HF : $H_2O$ : $C_2H_5OH$ = 1 : 1 : 1 |
| Process time | 11 (min) |
| Thickness of porous Si layer (target) | 12 ($\mu$m) |
| Porosity (target) | to 24% |

| <Second Anodizing Conditions> | |
|---|---|
| Current density | 10 (mA.cm$^{-2}$) |
| Anodizing solution | HF : $H_2O$ : $C_2H_5OH$ = 1 : 2 : 2 |
| Process time | 3 (min) |
| Thickness of porous Si layer (target) | 3 ($\mu$m) |
| Porosity (target) | to 35% |

In each of the anodizing apparatuses of the first to fourth embodiments, a substrate having a porous layer with a two-layered structure could be manufactured. In each of the apparatuses of the second and fourth anodizing apparatuses, two anodizing baths were used.

In the anodizing apparatus of the third embodiment, after a first porous layer was formed on each of 25 Si substrates, the electrolytic solutions and conductive diaphragm were exchanged, and a second porous layer was formed on each of the 25 Si substrates. Porous layers sequentially formed on each Si substrate used as the conductive diaphragm did not break.

In the anodizing apparatus of the fourth embodiment, first and second porous layers were sequentially formed on each of 25 Si substrates. Porous layers sequentially formed on each Si substrate used as the conductive diaphragm did not break.

The substrate having a porous layer was oxidized in an oxygen atmosphere at 400°C for 1 hr. Upon this oxidation, the inner wall of each pore in the porous Si layer was covered by a thermal oxide film.

Next, a 0.3-$\mu$m thick single-crystal Si layer was epitaxially grown on the porous Si layer by CVD (Chemical Vapor Deposition). The growth conditions were as follows. Since the surface of the porous Si layer is exposed to $H_2$ in the initial stage of epitaxial growth, the surface pores are filled to planarize the surface.

| <Epitaxial Growth Conditions> | |
|---|---|
| Source gas | $SiH_2Cl_2/H_2$ |
| Gas flow rate | 0.5/180 (liter/min) |
| Gas pressure | 80 (Torr) |
| Temperature | 950 (°C) |
| Growth rate | 0.3 (μm/min) |

Subsequently, a 200-nm thick $SiO_2$ layer was formed on the surface of the epitaxially grown single-crystal Si layer by thermal oxidation (completion of the first substrate).

The surface of this $SiO_2$ layer was brought into tight contact with the surface of an independently prepared Si substrate (second substrate), and these substrates were bonded by annealing at 1,000°C for one hr.

A water jet with a diameter of 0.2 mm was injected to the beveling gap of the bonded substrate stack to separate the bonded substrate stack into two substrates at the second (lower) porous Si layer.

The porous Si layer left on the second substrate side was etched using a mixed solution of 49% hydrofluoric acid, 30% hydrogen peroxide, and water. At this time, the single-crystal Si layer functioned as an etching stopper, so the porous Si layer was selectively etched.

The etching rate of non-porous single-crystal Si by the etchant is very low, and the ratio of the etching rate of porous single-crystal Si to non-porous single-crystal Si reaches 10 or more. For this reason, the etching amount (about several ten angstrom) of the non-porous layer can be neglected for practical use.

With the above process, an SOI substrate having a 0.2-μm thick single-crystal Si layer on the Si oxide film was obtained. The thickness of the single-crystal Si layer of this SOI substrate was measured at 100 points on the entire surface. The film thickness uniformity was 201 nm ± 4 nm.

The resultant structure was annealed in hydrogen at 1,100°C for 1 hr, and the surface roughness was evaluated with an atomic force microscope. The root mean square roughness in a 50-μm square area was approximately 0.2 nm. This nearly equals that of a commercially available Si wafer.

Cross section observation with a transmission electron microscope showed that no new crystal defects were formed in the Si layer, and satisfactory crystallinity was maintained.

The same result as described above was obtained even when no oxide film was formed on the surface of the epitaxially grown single-crystal Si layer.

Further, the same result as described above was obtained even when oxide film was formed on the surface of the second substrate or both of the surfaces on the first and second substrates.

The porous Si layer left on the first substrate side was also selectively etched using a mixed solution of 49% hydrofluoric acid, 30% hydrogen peroxide, and water. At this time, the single-crystal Si layer functioned as an etching stopper, so the porous Si layer was selectively etched. This substrate can be used again as a substrate for forming a first substrate in anodizing or as a second substrate in bonding.

Before the substrate was reused to form a first substrate, the substrate may be annealed in hydrogen at 1,100°C for 1 hr to restore the surface roughness (microroughness) due to micropores back to normal. However, planarization of the microroughness need not always be performed because when the substrate is to be reused to form a first substrate, surface planarization is performed simultaneously with sealing of pores on the surface of the porous Si layer during prebaking in hydrogen before epitaxial growth.

The microroughness due to micropores may be planarized not by annealing in hydrogen but by surface touch polishing.

[Example 5]

Example 5 is a modification of Example 4. More specifically, the first and second anodizing conditions were changed as follows.

| <First Anodizing Conditions> | |
|---|---|
| Current density | 7 (mA.cm$^{-2}$) |
| Anodizing solution | HF : $H_2O$ : $C_2H_5OH$ = 1 : 1 : 1 |
| Process time | 5 (min) |
| Thickness of porous Si layer (target) | (μm) |
| Porosity (target) | to 24% |

| <Second Anodizing Conditions> | |
|---|---|
| Current density | 30 (mA.cm$^{-2}$) |
| Anodizing solution | HF : H$_2$O : C$_2$H$_5$OH = 1 : 1 : 1 |
| Process time | 110 (sec) |
| Thickness of porous Si layer (target) | 3 ($\mu$m) |
| Porosity (target) | to 40% |

[Example 6]

Example 6 is a modification of Example 4. More specifically, the manufacturing conditions of Example 4 were changed as follows.

1) Thickness of epitaxial Si layer: 2 $\mu$m
2) Thickness of thermal oxide film on epitaxial Si layer: 0.1 $\mu$m
3) Second substrate: Si substrate having a 1.9-$\mu$m thick SiO$_2$ layer
4) Bonding: after the surfaces of first and second substrates were exposed to a nitrogen plasma, the substrates were brought into tight contact with each other and annealed at 400°C for 10 hrs.

[Example 7]

Example 7 is a modification of Example 4. More specifically, the manufacturing conditions of Example 4 were changed as follows.

1) Second substrate: silica or quartz substrate
2) Bonding: after the surfaces of first and second substrates were exposed to a nitrogen plasma or after the surfaces of first and second substrates were rinsed with water, the substrates were brought into tight contact with each other and annealed at 200°C for 24 hrs.
3) Annealing in hydrogen: the resultant structure was annealed in hydrogen at 970°C for 2 hrs, and the surface roughness was evaluated with an atomic force microscope. The root mean square roughness in a 50-$\mu$m square area was approximately 0.2 nm. This nearly equals that of a commercially available Si wafer.
4) Reuse: the first substrate side after separation was used in anodizing as a substrate for forming a first substrate.

[Example 8]

A single-crystal Si substrate was set in each of the anodizing apparatuses of the above embodiments, and a porous layer having a two-layered structure was formed. The first and second anodizing conditions were as follows.

| <First Anodizing Conditions> | |
|---|---|
| Current density | 7 (mA.cm$^{-2}$) |
| Anodizing solution | HF : H$_2$O : C$_2$H$_5$OH = 1 : 1 : 1 |
| Process time | 5 (min) |
| Thickness of porous Si layer (target) | 6 ($\mu$m) |
| Porosity (target) | to 24% |

| <Second Anodizing Conditions> | |
|---|---|
| Current density | 30 (mA.cm$^{-2}$) |
| Anodizing solution | HF : H$_2$O : C$_2$H$_5$OH = 1 : 1 : 1 |
| Process time | 110 (sec) |
| Thickness of porous Si layer (target) | 3 ($\mu$m) |
| Porosity (target) | to 40% |

In each of the anodizing apparatuses of the first to fourth embodiments, a substrate having a porous layer with a two-layered structure could be manufactured. In each of the apparatuses of the second and fourth anodizing apparatuses, two anodizing baths were used.

In the anodizing apparatus of the third embodiment, after a first porous layer was formed on each of 25 Si substrates, the electrolytic solutions and conductive diaphragm were exchanged, and a second porous layer was formed on each of the 25 Si substrates. Porous layers sequentially formed on each Si substrate used as the conductive diaphragm did not break.

In the anodizing apparatus of the fourth embodiment, first and second porous layers were sequentially formed on each of 25 Si substrates. Porous layers sequentially formed on each Si substrate used as the conductive diaphragm did not break.

The substrate having a porous layer was oxidized in an oxygen atmosphere at 400°C for 1 hr. Upon this oxidation, the inner wall of each pore in the porous Si layer was covered by a thermal oxide film.

Next, a 1-$\mu$m thick single-crystal GaAs layer was epitaxially grown on the porous Si layer by MOCVD (Metal Organic Chemical Vapor Deposition). The growth conditions were as follows.

| <Epitaxial Growth Conditions> | |
|---|---|
| Source gas | $TMG/AsH_3/H_2$ |
| Gas pressure | 80 (Torr) |
| Temperature | 700 (°C) |

The surface of the GaAs layer was brought into tight contact with the surface of an independently prepared Si substrate (second substrate).

A water jet with a diameter of 0.2 mm was injected to the beveling gap of the bonded substrate stack to separate the bonded substrate stack into two substrates at the second (lower) porous Si layer.

The porous Si layer left on the second substrate side was etched at 110°C using a mixed solution (etchant) of ethylenediamine/pyrocatechol/water (at a ratio of 17 ml : 3 g : 8 ml). At this time, the single-crystal GaAs layer functioned as an etching stopper, so the porous Si layer was selectively etched.

The etching rate of single-crystal GaAs by the etchant is very low, and the etching amount (about several ten angstrom) of the single-crystal GaAs can be neglected for practical use.

With the above process, a substrate having a 1-$\mu$m thick single-crystal GaAs layer on the single-crystal Si layer was obtained. The thickness of the single-crystal GaAs layer of this substrate was measured at 100 points on the entire surface. The film thickness uniformity was 1 $\mu$m $\pm$ 29.8 nm.

Cross section observation with a transmission electron microscope revealed that no new crystal defects were formed in the GaAs layer, and satisfactory crystallinity was maintained.

When an Si substrate having an oxide film was used as a support substrate, a substrate having a GaAs layer on an insulating film could be formed.

The porous Si layer left on the first substrate side was also selectively etched using a mixed solution of 49% hydrofluoric acid and 30% hydrogen peroxide under stirring. At this time, the single-crystal Si layer functioned as an etching stopper, so the porous Si layer was selectively etched. This substrate can be used again as a substrate for forming a first substrate in anodizing or as a second substrate in bonding.

Before the substrate was reused to form a first substrate, the substrate may be annealed in hydrogen at 1,100°C for 1 hr to restore the surface roughness (microroughness) due to micropores back to normal. However, planarization of the microroughness need not always be performed because when the substrate is to be reused to form a first substrate, surface planarization is performed simultaneously with sealing of pores on the surface of the porous Si layer during prebaking in hydrogen before epitaxial growth.

The microroughness due to micropores may be planarized not by annealing in hydrogen but by surface touch polishing.

[Example 9]

A single-crystal Si substrate was set in each of the anodizing apparatuses of the above embodiments, and a porous layer having a two-layered structure was formed. The first and second anodizing conditions were as follows.

| <First Anodizing Conditions> | |
|---|---|
| Current density | 7 (mA.cm$^{-2}$) |
| Anodizing solution | $HF : H_2O : C_2H_5OH = 1 : 1 : 1$ |
| Process time | 11 (min) |

(continued)

| <First Anodizing Conditions> | |
|---|---|
| Thickness of porous Si layer (target) | 12 (μm) |
| Porosity (target) | to 24% |

| <Second Anodizing Conditions> | |
|---|---|
| Current density | 10 (mA.cm$^{-2}$) |
| Anodizing solution | HF : H$_2$O : C$_2$H$_5$OH = 1 : 2 : 2 |
| Process time | 3 (min) |
| Thickness of porous Si layer (target) | 3 (μm) |
| Porosity (target) | to 35% |

In each of the anodizing apparatuses of the first to fourth embodiments, a substrate having a porous layer with a two-layered structure could be manufactured. In each of the apparatuses of the second and fourth anodizing apparatuses, two anodizing baths were used.

In the anodizing apparatus of the third embodiment, after a first porous layer was formed on each of 25 Si substrates, the electrolytic solutions and conductive diaphragm were exchanged, and a second porous layer was formed on each of the 25 Si substrates. Porous layers sequentially formed on each Si substrate used as the conductive diaphragm did not break.

In the anodizing apparatus of the fourth embodiment, first and second porous layers were sequentially formed on each of 25 Si substrates. Porous layers sequentially formed on each Si substrate used as the conductive diaphragm did not break.

The substrate having a porous layer was oxidized in an oxygen atmosphere at 400°C for 1 hr. Upon this oxidation, the inner wall of each pore in the porous Si layer was covered by a thermal oxide film.

A 1-μm thick single-crystal InP layer was epitaxially grown on the porous Si layer by MOCVD (Metal Organic Chemical Vapor Deposition).

After the surfaces of the InP layer and an independently prepared silica or quartz substrate (second substrate) were exposed to a nitrogen plasma, these surfaces were brought into tight contact with each other and annealed at 200°C for 10 hrs.

A water jet with a diameter of 0.2 mm was injected to the beveling gap of the bonded substrate stack to separate the bonded substrate stack into two substrates at the second (lower) porous Si layer.

The porous Si layer left on the second substrate side was selectively etched using a mixed solution of 49% hydrofluoric acid and 30% hydrogen peroxide under stirring. At this time, the single-crystal InP layer functioned as an etching stopper, so the porous Si layer was selectively etched.

The etching rate of single-crystal InP by the etchant is very low, and the etching amount (about several ten angstrom) of the single-crystal InP can be neglected for practical use.

With the above process, a substrate having a 1-μm thick single-crystal InP layer on the silica or quartz substrate was obtained. The thickness of the single-crystal InP layer of this substrate was measured at 100 points on the entire surface. The film thickness uniformity was 1 μm ± 29.0 nm.

Cross section observation with a transmission electron microscope indicated that no new crystal defects were formed in the InP layer, and satisfactory crystallinity was maintained.

The porous Si layer left on the first substrate side was also selectively etched using a mixed solution of 49% hydrofluoric acid and 30% hydrogen peroxide under stirring. At this time, the single-crystal Si layer functioned as an etching stopper, so the porous Si layer was selectively etched. This substrate can be used again as a substrate for forming a first substrate in anodizing.

Before the substrate was reused to form a first substrate, the substrate may be annealed in hydrogen at 1,100°C for 1 hr to restore the surface roughness (microroughness) due to micropores back to normal. However, planarization of the microroughness need not always be performed because when the substrate is to be reused to form a first substrate, surface planarization is performed simultaneously with sealing of pores on the surface of the porous Si layer during prebaking in hydrogen before epitaxial growth.

The microroughness due to micropores may be planarized not by annealing in hydrogen but by surface touch polishing.

[Example 10]

In Example 10, the bonded substrate stack separation method in Examples 4 to 9 was changed. More specifically, in Example 10, instead of using the water jet method, a thin resin wedge was inserted into the beveling gap of the bonded substrate stack to separate the bonded substrate stack into two substrates at the second (lower) porous Si layer.

[Example 11]

In Example 11, the processes described in Examples 4 to 9 were performed for both surfaces of a single-crystal Si substrate for forming a first substrate.

[Example 12]

A single-crystal Si substrate was set in each of the anodizing apparatuses of the above embodiments, and a porous layer having a four-layered structure was formed. The first to fourth anodizing conditions were as follows.

| <First Anodizing Conditions> | |
| --- | --- |
| Current density | 7 (mA.cm$^{-2}$) |
| Anodizing solution | HF : $H_2O$ : $C_2H_5OH$ = 1 : 1 : 1 |
| Process time | 5 (min) |
| Thickness of porous Si layer (target) | 6 ($\mu$m) |
| Porosity (target) | to 24% |

| <Second Anodizing Conditions> | |
| --- | --- |
| Current density | 10 (mA.cm$^{-2}$) |
| Anodizing solution | HF : $H_2O$ : $C_2H_5OH$ = 1 : 2 : 2 |
| Process time | 3 (min) |
| Thickness of porous Si layer (target) | 3 ($\mu$m) |
| Porosity (target) | to 35% |

| <Third Anodizing Conditions> | |
| --- | --- |
| Current density | 7 (mA.cm$^{-2}$) |
| Anodizing solution | HF : $H_2O$ : $C_2H_5OH$ = 1 : 1 : 1 |
| Process time | 5 (min) |
| Thickness of porous Si layer (target) | 6 ($\mu$m) |
| Porosity (target) | to 25% |

| <Fourth Anodizing Conditions> | |
| --- | --- |
| Current density | 20 (mA.cm$^{-2}$) |
| Anodizing solution | HF : $H_2O$ : $C_2H_5OH$ = 1 : 1 : 1 |
| Process time | 80 (sec) |
| Thickness of porous Si layer (target) | 1 ($\mu$m) |
| Porosity (target) | to 45% |

In each of the anodizing apparatuses of the first to fourth embodiments, a substrate having a porous layer with a four-layered structure could be manufactured. In each of the anodizing apparatuses of the first and third embodiments, the anodizing solution for the first, third, and fourth anodizing processes was supplied from the first and second tanks, and the anodizing solution for the second anodizing process was supplied from the third and fourth tanks. In each of the anodizing apparatuses of the second and fourth embodiments, four anodizing baths were used.

In the anodizing apparatus of the third embodiment, a first conductive diaphragm was set, and a first porous layer was formed on each of 25 Si substrates under the first anodizing conditions. Subsequently, a second conductive diaphragm was set, and a second porous layer was formed on each of the 25 Si substrates under the second anodizing conditions. Then, a third conductive diaphragm was set, and a third porous layer was formed on each of the 25 Si substrates under the third anodizing conditions. Finally, a fourth conductive diaphragm was set, and a fourth porous layer was formed on each of the 25 Si substrates under the fourth anodizing conditions. Porous layers sequentially formed on each Si substrate used as the conductive diaphragm did not break.

In the anodizing apparatus of the fourth embodiment, first to fourth porous layers were sequentially formed on each of 25 Si substrates. Porous layers sequentially formed on each Si substrate used as the conductive diaphragm did not break.

[Others]

In the above examples, to epitaxially grow a non-porous layer such as a single-crystal Si layer on the porous Si layer, not only CVD but also MBE, sputtering, or liquid phase epitaxial growth can be employed.

The etchant for selectively etching the porous Si layer is not limited to the mixed solution of 49% hydrofluoric acid and 30% hydrogen peroxide. For example,

1) a mixed solution of hydrofluoric acid and water
2) a mixed solution prepared by adding at least one of an alcohol and hydrogen peroxide to a mixed solution of hydrofluoric acid and water
3) buffered hydrofluoric acid
4) a mixed solution prepared by adding at least one of an alcohol and hydrogen peroxide to buffered hydrofluoric acid, or
5) a mixed solution of hydrofluoric acid, nitric acid, and acetic acid can be used. The porous Si layer has a large surface area and therefore can be selectively etched using various etchants.

To separate the bonded substrate stack, various methods can be employed in addition to the separation method using a fluid as an application of the water jet method.

The remaining processes can be performed not only by the methods of the above examples but also by various methods.

As described above, by exchanging the electrolytic solution for anodizing every time one porous layer is formed, the porosity of the resultant porous layer can be precisely controlled.

In addition, when one conductive diaphragm is used under the same anodizing conditions, break of the conductive diaphragm can be suppressed.

According to the present invention, a porous layer having a multilayered structure can be formed.

The present invention is not limited to the above embodiments and various changes and modifications can be made within the spirit and scope of the present invention. Therefore, to apprise the public of the scope of the present invention, the following claims are made.

## Claims

1.  An anodizing method of forming a porous layer (12, 13) on a substrate (102), characterized by comprising the steps of:

    preparing an anodizing bath (101) used to anodize a substrate (102),
    anodizing said substrate (102) to be processed in a first electrolytic solution (141, 151) while holding said substrate (102) between an anode (106) and a cathode (104) in said anodizing bath (101),
    exchanging the first electrolytic solution (141, 151) with a second electrolytic solution (142, 152), and anodizing said substrate (102) in the second electrolytic solution (142, 152), thereby forming a porous layer (12, 13) having a multilayered structure on said substrate (102).

2.  The method according to claim 1, characterized in that a current density of a current to be flowed across said anode (106) and said cathode (104) is changed between anodizing using the first electrolytic solution (141, 151) and anodizing using the second electrolytic solution (142, 152).

3.  The method according to claim 1 or 2, characterized in that a conductive diaphragm (108) is inserted between said anode (106a) and said substrate (102) to be processed to prevent contamination of said substrate (102) by said anode (106a).

4. The method according to claim 3, characterized in that said conductive diaphragm (108) is arranged to flow the whole current from said anode (106a) to said substrate (102) to be processed through said conductive diaphragm (108).

5. The method according to claim 3, characterized in that said conductive diaphragm (108) is arranged to cover a surface of said anode (106a) that opposes a backside surface of said substrate (102) to be processed.

6. The method according to claim 3, characterized in that said conductive diaphragm (108) is arranged to isolate an electrolytic solution in contact with a surface of said substrate (102) to be processed, that is on said anode (106) side, from an electrolytic solution in contact with said anode (106).

7. The method according to any one of claims 4 to 6, characterized in that at least a surface of said conductive diaphragm (108) that opposes said substrate to be processed is formed from a silicon material.

8. The method according to claim 4, characterized by further comprising the step of changing said conductive diaphragm (108) every time an anodizing condition is changed.

9. The method according to claim 4, characterized by further comprising the step of preparing a conductive diaphragm (108) corresponding to each anodizing condition, and every time the anodizing condition is changed, using a conductive diaphragm (108) corresponding to the condition.

10. The method according to any one of claims 1 to 9, characterized by further comprising the step of forming a porous layer having a relatively low porosity as a surface layer (12) of said substrate (102) to be processed, and forming a porous layer having a relatively high porosity as an underlayer (13) of said surface layer.

11. The method according to claim 10, characterized by further comprising the step of anodizing to form a porous layer having a porosity of not more than 30% as said surface layer (12).

12. The method according to claim 10, characterized by further comprising the step of anodizing to form a porous layer having a porosity of not less than 30% as said underlayer (13) of said surface layer (12).

13. The method according to any one of claims 10 to 12, characterized by further comprising the step of anodizing to form a porous layer having a thickness of not more than 5 μm as said underlayer (13) of said surface layer (12).

14. An anodizing method of forming a porous layer (12, 13) on a substrate (102), characterized by comprising the step of:

preparing at least two anodizing baths (101a - 101c) used to anodize a substrate (102), anodizing said substrate (102) to be processed while holding said substrate (102) between an anode (106) and a cathode (104) in one anodizing bath (101a), and anodizing said substrate (102) while holding said substrate (102) between an anode (106) and a cathode (104) in the next anodizing bath (101b), thereby forming a porous layer (12, 13) having a multilayered structure on said substrate (102).

15. The method according to claim 14, characterized in that different electrolytic solutions (201 - 204) are used as electrolytic solutions used for anodizing in all or some of said at least two anodizing baths (101a - 101c).

16. The method according to claim 14 or 15, characterized in that a current density of a current to be flowed across said anode (106) and said cathode (104) is changed in anodizing in all or some of said at least two anodizing baths (101a - 101c).

17. The method according to any one of claims 14 to 16, characterized in that a conductive diaphragm (108) is inserted between said anode (106a) and said substrate (102) to be processed to prevent contamination of said substrate (102) by said anode (106a).

18. The method according to claim 17, characterized in that said conductive diaphragm (108) is arranged to flow the whole current from said anode (106a) to said substrate (102) to be processed through said conductive diaphragm (108).

19. The method according to claim 17, characterized in that said conductive diaphragm (108) is arranged to cover a surface of said anode (106a) that opposes a backside surface of said substrate (102) to be processed.

20. The method according to claim 17, characterized in that said conductive diaphragm (108) is arranged to isolate an electrolytic solution in contact with a surface of said substrate (102) to be processed, that is on said anode (106) side, from an electrolytic solution in contact with said anode (106).

21. The method according to any one of claims 17 to 20, characterized in that at least a surface of said conductive diaphragm (108) that opposes said substrate (102) to be processed is formed from a silicon material.

22. The method according to claim 21, characterized by further comprising the step of changing said conductive diaphragm (108) every time an anodizing condition is changed.

23. The method according to claim 21, characterized by further comprising the step of preparing a conductive diaphragm (108) corresponding to each anodizing condition, and every time the anodizing condition is changed, using a conductive diaphragm (108) corresponding to the condition.

24. The method according to any one of claims 14 to 23, characterized by further comprising the step of forming a porous layer having a relatively low porosity as a surface layer (12) of said substrate (102) to be processed, and forming a porous layer having a relatively high porosity as an underlayer (13) of said surface layer.

25. The method according to claim 24, characterized by further comprising the step of anodizing to form a porous layer having a porosity of not more than 30% as said surface layer (12).

26. The method according to claim 24, characterized by further comprising the step of anodizing to form a porous layer having a porosity of not less than 30% as said underlayer (13) of said surface layer (12).

27. The method according to any one of claims 24 to 26, characterized by further comprising the step of anodizing to form a porous layer having a thickness of not more than 5 $\mu$m as said underlayer (13) of said surface layer (12).

28. A semiconductor substrate manufacturing method characterized by comprising the steps of:

processing a first substrate (11) using the anodizing method of any one of claims 1 to 27 to form a porous layer (12, 13) having a multilayered structure on said first substrate (11);
forming at least one non-porous layer (14, 15) on said porous layer (12, 13);
bonding a second substrate (16) to a surface of said non-porous layer (14, 15) of said first substrate;
separating a bonded substrate stack to a side of said first substrate and a side of said second substrate at a portion of said porous layer (12, 13); and
removing said porous layer (12, 13) left on the side of said separated second substrate.

29. The method according to claim 28, characterized by further comprising the step of removing said porous layer (12, 13) left on the side of said separated first substrate to allow reuse of said first substrate.

30. The method according to claim 28 or 29, characterized in that the separation step comprises separating said bonded substrate stack at a portion (13) having a high porosity in said porous layer (12, 13) having the multilayered structure.

31. The method according to any one of claims 28 to 30, characterized in that said non-porous layer (14, 15) contains a single-crystal silicon layer (14).

32. The method according to any one of claims 28 to 30, characterized in that said non-porous layer (14, 15) comprises a single-crystal silicon layer (14) and a silicon oxide layer (15) which are sequentially formed on said porous layer (12, 13).

33. The method according to any one of claims 28 to 30, characterized in that said non-porous layer (14, 15) contains a compound semiconductor layer.

34. The method according to any one of claims 28 to 33, characterized in that said second substrate (16) comprises a silicon substrate.

35. The method according to any one of claims 28 to 34, characterized in that said second substrate (16) comprises a substrate having a silicon oxide layer formed on a surface to be bonded to said first substrate.

36. The method according to any one of claims 28 to 33, characterized in that said second substrate (16) comprises a transparent substrate.

37. The method according to any one of claims 28 to 36, characterized further comprising, after the step of removing said porous layer (12, 13), the step of planarizing a surface layer on the side of said second substrate (16).

38. The method according to claim 37, characterized in that the planarization step comprises annealing in an atmosphere containing hydrogen.

39. The method according to any one of claims 28 to 38, characterized in that the step of removing said porous layer (12, 13) comprises selectively etching said porous layer (12, 13) using, as an etchant, any one of

   a) hydrofluoric acid,
   b) a mixed solution prepared by adding at least one of an alcohol and hydrogen peroxide to hydrofluoric acid,
   c) buffered hydrofluoric acid, and
   d) a mixed solution prepared by adding at least one of an alcohol and hydrogen peroxide to buffered hydrofluoric acid.

40. The method according to claim 33, characterized in that the step of removing said porous layer (12, 13) comprises selectively etching said porous layer (12, 13) using an etchant whose etching rate for said porous layer (12, 13) is higher than that for a compound semiconductor.

41. The method according to any one of claims 28 to 38, characterized in that the step of removing said porous layer (12, 13) comprises selectively polishing said porous layer (12, 13) using said non-porous layer (14) as a stopper.

42. The method according to any one of claims 28 to 41, characterized in that the bonding step comprises the step of bringing said first substrate having said non-porous layer (14, 15) into tight contact with said second substrate (16).

43. The method according to any one of claims 28 to 41, characterized in that the bonding step comprises, after the step of bringing said first substrate having said non-porous layer (14, 15) into tight contact with said second substrate (16), the step of performing a process selected from the group consisting of anode bonding, pressing, heating, and a combination thereof.

44. A semiconductor substrate capable of being manufactured by the manufacturing method of any one of claims 28 to 43.

45. A semiconductor substrate in a process of executing the manufacturing method of any one of claims 28 to 43.

46. A substrate having a porous layer formed by the anodizing method of any one of claims 1 to 27.

47. An anodizing apparatus for executing the anodizing method of any one of claims 1 to 27.

48. An anodizing apparatus for forming a porous layer on a substrate, characterized by comprising:

   an anodizing bath (101) having an anode (106) and a cathode (104);
   a plurality of tanks (121, 131, 122, 132) for storing electrolytic solutions (141, 151, 142, 152) to be supplied to said anodizing bath (101);
   a supply mechanism (162, 172, 181, 164, 174, 182) for selectively supplying the electrolytic solution (141, 151, 142, 152) stored in any one of said plurality of tanks (121, 131, 122, 132) to said anodizing bath (101);

and

a drain mechanism for draining off the electrolytic solution (141, 151, 142, 152) from said anodizing bath (101) back into said tank (121, 131, 122, 132) which supplied the electrolytic solution (141, 151, 142, 152).

49. The apparatus according to claim 48, characterized in that said apparatus further comprises a holding mechanism (107a) for holding a conductive diaphragm (108) between said anode (106a) and a substrate (102) to be processed, and said conductive diaphragm (108) prevents contamination of said substrate (102) by said anode (106a).

50. The apparatus according to claim 49, characterized in that said holding mechanism (107a) holds said conductive diaphragm (108) to flow a whole current from said anode (106a) to said substrate (102) to be processed through said conductive diaphragm (108).

51. The apparatus according to claim 49, characterized in that said holding mechanism (107a) holds said conductive diaphragm (108) to cover a surface of said anode (106a) that opposes a backside surface of said substrate (102) to be processed.

52. The apparatus according to claim 49, characterized in that said holding mechanism (107a) holds said conductive diaphragm (108) to isolate an electrolytic solution in contact with a surface of said substrate (102) to be processed, that is on said anode (106) side, from an electrolytic solution in contact with said anode (106).

53. The apparatus according to any one of claims 49 to 52, characterized in that at least a surface of said conductive diaphragm (108) that opposes said substrate (102) to be processed is formed from a silicon material.

54. The apparatus according to any one of claims 49 to 53, characterized in that said holding mechanism (107a) detachably holds said conductive diaphragm (108).

55. An anodizing apparatus for forming a porous layer (12, 13) on a substrate (102), characterized by comprising:

at least two anodizing baths (101a - 101c) each having an anode (106) and a cathode (104); and
a conveyor mechanism (721, 722) for conveying a substrate (102) anodized in one anodizing bath (101a) into the next anodizing bath (101b).

56. The apparatus according to claim 55, characterized in that said substrate (102) is anodized in all or some of said at least two anodizing baths (101a - 101c) under different conditions.

57. The apparatus according to claim 55 or 56,
characterized by further comprising

a cleaning unit (703) for cleaning said substrate (102) processed in said final anodizing bath (101b) of said at least two anodizing baths (101a, 101b), and
a drier unit (704) for drying said substrate (102) cleaned by said cleaning unit (703).

58. The apparatus according to any one of claims 55 to 57, characterized in that each of said anodizing baths (101a - 101c) comprises a holding mechanism (107a) for holding a conductive diaphragm (108) between said anode (106a) and said substrate (102) to be processed, and said conductive diaphragm (108) prevents contamination of said substrate (102) by said anode (106a).

59. The apparatus according to claim 58, characterized in that said holding mechanism (107a) holds said conductive diaphragm (108) to flow a whole current from said anode (106a) to said substrate (102) to be processed through said conductive diaphragm (108).

60. The apparatus according to claim 58, characterized in that said holding mechanism (107a) holds said conductive diaphragm (108) to cover a surface of said anode (106a) that opposes said substrate (102) to be processed.

61. The apparatus according to claim 58, characterized in that said holding mechanism (107a) holds said conductive diaphragm (108) to isolate an electrolytic solution in contact with a surface of said substrate (102) to be processed, that is on said anode (106) side, from an electrolytic solution in contact with said anode (106).

**62.** The apparatus according to any one of claims 59 to 61, characterized in that at least a surface of said conductive diaphragm (108) that opposes said substrate (102) to be processed is formed from a silicon material.

**63.** The apparatus according to any one of claims 55 to 62, characterized in that said holding mechanism (107a) detachably holds said conductive diaphragm (108).

# F I G. 1A

# F I G. 1B

# F I G. 1C

# F I G. 1D

# F I G. 1E

# F I G. 1F

# F I G. 2

EP 0 940 483 A2

FIG. 3

EP 0 940 483 A2

**F I G. 4**

EP 0 940 483 A2

FIG. 5

# F I G. 6

FIG. 7

EP 0 940 483 A2

# FIG. 8

EP 0 940 483 A2